# EUROPEAN PATENT APPLICATION

(11) **EP 2 547 184 A1**
(43) Date of publication of application: **16.01.2013**
(21) Application number: 11753264.8
(22) Date of filing: 03.03.2011
(51) Int. Cl.: H05K 3/46, H01P 1/04, H01P 5/107

(54) **INDUCTIVE COUPLING STRUCTURE, MULTI-LAYER TRANSMISSION-LINE PLATE, METHOD OF MANUFACTURING INDUCTIVE COUPLING STRUCTURE, AND METHOD OF MANUFACTURING MULTI-LAYER TRANSMISSION-LINE PLATE**

(30) Priority: 04.02.2011 JP 2011022964; 09.03.2010 JP 2010051986
(71) Applicant: Hitachi Chemical Company, Ltd., Tokyo 163-0449 (JP)
(72) Inventor: MIZUSHIMA Etsuo, Chikusei-shi Ibaraki 308-0861 (JP); KONDOU Yuusuke, Chikusei-shi Ibaraki 308-0861 (JP); MIZUNO Yasuyuki, Chikusei-shi Ibaraki 308-0861 (JP); WATANABE Yasushi, Chikusei-shi Ibaraki 308-8524 (JP)
(74) Representative: HOFFMANN EITLE
(86) International application number: PCT/JP2011/054946
(87) International publication number: WO 2011/111605

(57) **Abstract**

An electromagnetic field coupling structure that is used in a microwave band frequency band, includes: a laminated body in which an inner dielectric layer 23 is sandwiched and laminated between a plurality of inner conductor layers 12 and 15 which become a plurality of ground layers; a pair of outer dielectric layers 21 and 25 facing each other with the laminated body interposed therebetween; and a pair of outer conductor layers 11 and 16 facing each other with the pair of outer dielectric layers 21 and 25 interposed therebetween. The laminated body is provided with a hole S which penetrates the inner dielectric layer 23 and the inner conductor layers 12 and 15 which become the plurality of ground layers, and the inner conductor layers 12 and 15 which become the plurality of ground layers are electrically connected via a tubular metal film 3 formed on an inner wall of the hole S, whereby the pair of outer conductor layers 11 and 16 are electromagnetically coupled.

## Description

### Technical Field

The present invention relates to an electromagnetic field coupling structure, a multi-layer transmission-line plate, a method of manufacturing an electromagnetic field coupling structure, and a method of manufacturing a multi-layer transmission-line plate.

### Background Art

As a method for electrical connection between layers of a transmission-line substrate in a microwave band or millimeter wave band high frequency band, there is proposed a method using electromagnetic field coupling. For example, in Patent Literature 1, there is described an electromagnetic field coupling structure between layers in a multi-layer wiring board.

### Citation List

### Patent Literature

[Patent Literature 1] Japanese Unexamined Patent Application Publication No. 2007-243123

### Summary of Invention

### Technical Problem

In the multi-layer wiring board described in Patent Literature 1, a first transmission line, a first dielectric, a first ground conductor having a slot, a second dielectric, a second ground conductor having a separate slot at a position corresponding to the above-mentioned slot, a third dielectric, and a second transmission line are laminated and formed in this order. The first ground conductor and the second ground conductor are electrically connected by via hole groups formed periodically around the slots. In this manner, the first ground conductor and the second ground conductor are electrically connected through the via hole groups, whereby the first transmission line and the second transmission line are connected in an electromagnetic field manner. In addition, the slot of the first ground conductor and the slot of the second ground conductor do not pass through the second dielectric disposed between the first ground conductor and the second ground conductor.

Here, the via hole group disclosed in Patent Literature 1 is provided in a relatively wide range around the slot of each of the first ground conductor and the second ground conductor. Therefore, a space for disposing the via hole group around the slot is required, and thus it is not possible to provide, for example, an electromagnetic field coupling structure using a separate slot in proportion to the space. In this manner, in the multi-layer wiring board in the related art, a technique of making an electromagnetic field coupling structure to be integrated at high density is required.

The present invention has been made in order to solve the above-described problems and an object of the invention is to provide an electromagnetic field coupling structure which can be integrated at high density, a multi-layer transmission-line plate, and methods of manufacturing the electromagnetic field coupling structure and the multi-layer transmission-line plate.

### Solution to Problem

In order to solve the above-described problems, according to an aspect of the invention, there is provided an electromagnetic field coupling structure used in a microwave band frequency band, comprising: a laminated body comprising an inner dielectric layer sandwiched and laminated between a plurality of inner conductor layers becoming a plurality of ground layers; a pair of outer dielectric layers facing each other with the laminated body interposed therebetween; and a pair of outer conductor layers facing each other with the pair of outer dielectric layers interposed therebetween, wherein the laminated body is provided with a hole penetrating the inner dielectric layer and the plurality of inner conductor layers becoming the plurality of ground layers, and the plurality of inner conductor layers becoming the plurality of ground layers are electrically connected via a tubular metal film formed on an inner wall of the hole, to electromagnetically couple the pair of outer conductor layers.

In the electromagnetic field coupling structure according to this aspect, in the laminated body having a structure comprising the inner dielectric layer sandwiched between a plurality of the inner conductor layers becoming the plurality of ground layers, the hole penetrating the inner dielectric layer and the inner conductor layers becoming the plurality of ground layers, is provided. On the inner wall of the hole, the tubular metal film which electrically connects the inner conductor layers which become the plurality of ground layers, is provided. Therefore, the pair of outer conductor layers is electromagnetically coupled via the pair of outer dielectric layers disposed on the outsides of the laminated body. According to this electromagnetic field coupling structure, it is not necessary to provide the via hole group or the like disclosed in, for example, Patent Literature 1 around the hole. Therefore, an electromagnetic field coupling structure such as a hole having another tubular metal film on the inner wall can be disposed around the hole having the tubular metal film on the inner wall, without providing, for example, the via hole group. Therefore, an electromagnetic field coupling structure which can be integrated at high density can be provided.

Further, according to another aspect of the invention, there is provided an electromagnetic field coupling structure used in a microwave band frequency band, comprising: a first conductor layer; a first dielectric layer; a second conductor layer, a second dielectric layer, a third conductor layer, a third dielectric layer, and a fourth conductor layer in this order, wherein a hole penetrating the second conductor layer, the second dielectric layer, and the third conductor layer is provided, and the second conductor layer and the third conductor layer are electrically connected via a tubular metal film formed on an inner wall of the hole, to electromagnetically coupled the first conductor layer to the fourth conductor layer.

In the electromagnetic field coupling structure according to this aspect, the hole penetrating the second conductor layer, the second dielectric layer, and the third conductor layer is provided. On the inner wall of the hole, the tubular metal film which electrically connects the second conductor layer and the third conductor layer is provided. Therefore, the first conductor layer and the fourth conductor layer are electromagnetically coupled via the first dielectric layer, the tubular metal film formed on the inner wall of the hole, and the third dielectric layer. According to this structure, it is not necessary to provide the via hole group or the like disclosed in, for example, Patent Literature 1 around the hole. Therefore, an electromagnetic field coupling structure such as a hole having another tubular metal film on the inner wall can be disposed around the hole having the tubular metal film on the inner wall, without providing, for example, the via hole group. Therefore, an electromagnetic field coupling structure which can be integrated at high density can be provided.

Further, according to still another aspect of the invention, there is provided a multi-layer transmission-line plate used in a microwave band frequency band, comprising: a laminated body comprising an inner dielectric layer sandwiched and laminated between a plurality of inner conductor layers becoming a plurality of ground layers; a pair of outer dielectric layers facing each other with the laminated body interposed therebetween; and a pair of outer conductor layers facing each other with the pair of outer dielectric layers interposed therebetween and form transmission lines, wherein the laminated body is provided with a hole penetrating the inner dielectric layer and the inner conductor layers becoming the plurality of ground layers, and the inner conductor layers becoming the plurality of ground layers are electrically connected via a tubular metal film formed on an inner wall of the hole, to electromagnetically couple the pair of outer conductor layers.

In the multi-layer transmission-line plate according to this aspect, in the laminated body having a structure comprising the inner dielectric layer sandwiched between the inner conductor layers becoming the plurality of ground layers, the hole penetrating the inner dielectric layer and the plurality of inner conductor layers becoming the plurality of ground layers is provided. On the inner wall of the hole, the tubular metal film which electrically connects the plurality of inner conductor layers becoming the plurality of ground layers is provided. Therefore, the pair of outer conductor layers is electromagnetically coupled via the pair of outer dielectric layers disposed on the outsides of the laminated body. According to the structure of this multi-layer transmission-line plate, it is not necessary to provide the via hole group or the like disclosed in, for example, Patent Literature 1 around the hole. Therefore, an electromagnetic field coupling structure such as a hole having another tubular metal film on the inner wall can be disposed around the hole having the tubular metal film on the inner wall, without providing, for example, the via hole group. Therefore, a multi-layer transmission-line plate in which an electromagnetic field coupling structure can be integrated at high density can be provided.

Further, according to still yet another aspect of the invention, there is provided a multi-layer transmission-line plate used in a microwave band frequency band, including: a first conductor layer forming a first transmission line, a first dielectric layer; a second conductor layer; a second dielectric layer, a third conductor layer, a third dielectric layer, and a fourth conductor layer forming a second transmission line, in this order, wherein a hole penetrating the second conductor layer, the second dielectric layer, and the third conductor layer is provided, and the second conductor layer and the third conductor layer are electrically connected via a tubular metal film formed on an inner wall of the hole, to electromagnetically coupled the first conductor layer to the fourth conductor layer.

In the multi-layer transmission-line plate according to this aspect, the hole penetrating the second conductor layer, the second dielectric layer, and the third conductor layer is provided. On the inner wall of the hole, the tubular metal film which electrically connects the second conductor layer and the third conductor layer is provided. Therefore, the first transmission line and the second transmission line are electromagnetically coupled via the first dielectric layer, the tubular metal film formed on the inner wall of the hole, and the third dielectric layer. According to this structure, it is not necessary to provide the via hole group or the like disclosed in, for example, Patent Literature 1 around the hole. Therefore, an electromagnetic field coupling structure such as a hole having another tubular metal film on the inner wall can be disposed around the hole having the tubular metal film on the inner wall, without providing, for example, the via hole group. Therefore, a multi-layer transmission-line plate in which an electromagnetic field coupling structure can be integrated at high density can be provided.

Further, in the electromagnetic field coupling structure described above, it is preferable that the outer conductor layers extend in in-plane directions of the pair of outer dielectric layers and the width of the hole in a direction orthogonal to extending directions of the outer conductor layers be set to be equal to or less than an effective wavelength corresponding to a frequency which is used.

Further, in the electromagnetic field coupling structure described above, it is preferable that the first conductor layer extend in an in-plane direction of the first dielectric layer, the fourth conductor layer extend in an in-plane direction of the third dielectric layer, and the width of the hole in a direction orthogonal to an extending direction of the fourth conductor layer be set to be equal to or less than an effective wavelength corresponding to a frequency which is used.

Further, in the multi-layer transmission-line plate described above, it is preferable that the outer conductor layers forming transmission lines extend in in-plane directions of the pair of outer dielectric layers and the width of the hole in a direction orthogonal to extending directions of the outer conductor layers forming transmission lines be set to be equal to or less than an effective wavelength corresponding to a frequency which is used.

Further, in the multi-layer transmission-line plate described above, it is preferable that the first conductor layer forming the first transmission line extend in an in-plane direction of the first dielectric layer, the fourth conductor layer forming the second transmission line extend in an in-plane direction of the third dielectric layer, and the width of the hole in a direction orthogonal to an extending direction of the fourth conductor layer be set to be equal to or less than an effective wavelength corresponding to a frequency which is used. In addition, the width of the hole in the extending direction of the fourth conductor layer is shorter than the width of the hole in a direction orthogonal to the extending directions of the first conductor layer and the fourth conductor layer.

By setting the width of the hole in this manner, it is possible to achieve high-density integration of the electromagnetic field coupling while suppressing transmission loss. Further, in the electromagnetic field coupling structure or the multi-layer transmission-line plate described above, from the viewpoint of production efficiency, it is preferable that the tubular metal film be a plated film.

Further, in the electromagnetic field coupling structure or the multi-layer transmission-line plate described above, it is preferable that the hole with the tubular metal film formed therein be filled with a dielectric that satisfies at least one of a dielectric loss tangent at 10 GHz in a range of 0 to 0.0300 and a relative permittivity at 10 GHz in a range of 2 to 30.

Since transmission loss increases in proportion to the dielectric loss tangent of a material, by filling the hole with a dielectric having a low dielectric loss tangent in this manner, transmission loss can be suppressed. Further, since the wavelength of a signal passing through the inside of the hole is shortened by filling the hole with the dielectric having a high relative permittivity, the width of the hole also becomes narrow according to this, so that the densification of the electromagnetic field coupling structure becomes possible and it also leads to a reduction in drilling cost. At this time, if the relative permittivity of the dielectric which is filled in the hole becomes large, transmission loss increases. However, both the densification and the suppression of transmission loss can be achieved by filling the hole with the dielectric having a low dielectric loss tangent.

Further, the hole with the tubular metal film formed therein may also be filled with air. Also in this case, similarly to a case where the hole is filled with the dielectric, transmission loss can be suppressed. Further, a step of filling the hole with the dielectric can be omitted, so that simplification of the process can be attained.

Further, according to another aspect of the invention, there is provided a method of manufacturing an electromagnetic field coupling structure used in a microwave band frequency band, the method including: a step of forming a laminated body comprising an inner dielectric layer is disposed between a plurality of inner conductor layers becoming a ground layers; a step of providing a hole penetrating the inner dielectric layer and the inner conductor layers becoming the ground layers in the laminated body; a step of providing a tubular metal film on an inner wall of the hole; a step of forming a pair of outer dielectric layers facing each other with the laminated body interposed therebetween; and a step of forming a pair of outer conductor layers facing each other with the pair of outer dielectric layers interposed therebetween. According to this manufacturing method, it is possible to efficiently produce the electromagnetic field coupling structure described above.

Further, according to still another aspect of the invention, there is provided a method of manufacturing a multi-layer transmission-line plate used in a microwave band frequency band, the method including: a step of forming a laminated body comprising an inner dielectric layer disposed between a plurality of inner conductor layers becoming a plurality of ground layers; a step of providing a hole penetrating the inner dielectric layer and the inner conductor layers becoming the ground layers in the laminated body; a step of providing a tubular metal film on an inner wall of the hole; a step of forming a pair of outer dielectric layers facing each other with the laminated body interposed therebetween; and a step of forming a pair of outer conductor layers facing each other with the pair of outer dielectric layers interposed therebetween. According to this manufacturing method, it is possible to efficiently produce the multi-layer transmission-line plate described above.

Further, in the method of manufacturing an electromagnetic field coupling structure or the method of manufacturing a multi-layer transmission-line plate described above, from the viewpoint of further improvement in production efficiency, it is preferable that the tubular metal film be formed by plating.

Further, it is preferable that the method of manufacturing an electromagnetic field coupling structure or the method of manufacturing a multi-layer transmission-line plate described above further include a step of filling the hole with the tubular metal film formed therein, with a dielectric that satisfies at least one of a dielectric loss tangent at 10 GHz in a range of 0 to 0.0300 and a relative permittivity at 10 GHz in a range of 2 to 30.

Since transmission loss increases in proportion to the dielectric loss tangent of a material, by filling the hole with a dielectric having a low dielectric loss tangent in this manner, transmission loss can be suppressed. Further, since the wavelength of a signal passing through the inside of the hole is shortened by filling the hole with the dielectric having a high relative permittivity, the width of the hole also becomes narrow according to this, so that the densification of the electromagnetic field coupling structure becomes possible and it also leads to a reduction in drilling cost. At this time, if the relative permittivity of the dielectric which is filled in the hole becomes large, transmission loss increases. However, both the densification and the suppression of transmission loss can be achieved by filling the hole with the dielectric having a low dielectric loss tangent.

Further, it is also preferable to further include a step of filling the hole with the tubular metal film formed therein, with air. Also in this case, similarly to a case where the hole is filled with the dielectric, transmission loss can be suppressed. Further, since the step of filling the hole with the dielectric can be further simplified, it is preferable.

### Advantageous Effects of Invention

According to the invention, it is possible to provide an electromagnetic field coupling structure which can be integrated at high density, a multi-layer transmission-line plate, and methods of manufacturing the electromagnetic field coupling structure and the multi-layer transmission-line plate.

### Brief Description of Drawings

[Fig. 1] Fig. 1 is an exploded perspective view showing an embodiment of a multi-layer transmission-line plate having an electromagnetic field coupling structure related to an embodiment.
[Fig. 2] Fig. 2 is a cross-sectional view along line II-II of Fig. 1.
[Fig. 3] Figs. 3(a) to 3(c) are diagrams showing an example of a method of manufacturing the multi-layer transmission-line plate having the electromagnetic field coupling structure related to the embodiment.
[Fig. 4] Figs. 4(a) to 4(c) are diagrams showing an example of the method of manufacturing the multi-layer transmission-line plate having the electromagnetic field coupling structure related to the embodiment.
[Fig. 5] Fig. 5 is a cross-sectional view showing a modified example of the multi-layer transmission-line plate having the electromagnetic field coupling structure related to the embodiment.
[Fig. 6] Fig. 6 is a cross-sectional view showing another modified example of the multi-layer transmission-line plate having the electromagnetic field coupling structure related to the embodiment.
[Fig. 7] Fig. 7(a) is a top perspective diagram showing a structure replacing the configuration of a transmission line in order to measure high frequency characteristics in multi-layer transmission-line plates having electromagnetic field coupling structures related to Examples 1 to 3. Fig. 7(b) is a cross-sectional view along line VIIb-VIIb of Fig. 7(a).
[Fig. 8] Fig. 8(a) is a top perspective diagram showing a structure replacing the configuration of a transmission line in order to measure a high frequency characteristic in a multi-layer transmission-line plate having an electromagnetic field coupling structure related to Example 4. Fig. 8(b) is a cross-sectional view along line VIIIb-VIIIb of Fig. 8(a).
[Fig. 9] Fig. 9 is an exploded perspective view showing a multi-layer transmission-line plate having an electromagnetic field coupling structure related to Comparative Example 1.
[Fig. 10] Fig. 10 is a cross-sectional view along line X-X of Fig. 9.
[Fig. 11] Fig. 11(a) is a top perspective diagram showing a structure for measuring a high frequency characteristic in the multi-layer transmission-line plate having the electromagnetic field coupling structure related to Comparative Example 1. Fig. 11(b) is a cross-sectional view along line XIb-XIb of Fig. 11 (a).
[Fig. 12] Fig. 12 is an exploded perspective view showing a multi-layer transmission-line plate having an electromagnetic field coupling structure related to Comparative Example 2.
[Fig. 13] Fig. 13(a) is a top perspective diagram showing a structure for measuring the electromagnetic field coupling structure related to Comparative Example 2. Fig. 13(b) is a cross-sectional view along line XIIIb-XIIIb of Fig. 13(a).
[Fig. 14] Fig. 14 is a graph showing the measurement results of high frequency characteristics in Example 1 and Comparative Example 1.
[Fig. 15] Fig. 15 is a graph showing the measurement results of high frequency characteristics in Examples 1 to 3.
[Fig. 16] Fig. 16 is a graph showing the measurement results of a high frequency characteristic in Comparative Example 2.
[Fig. 17] Fig. 17 is a graph showing the measurement results of a high frequency characteristic in Example 4.

### Description of Embodiments

Hereinafter, a preferred embodiment of a multi-layer transmission-line plate having an electromagnetic field coupling structure according to the invention will be described in detail with reference to the drawings. In the drawings, an X-Y-Z orthogonal coordinate axes system C is shown appropriately.

The multi-layer transmission-line plate having the electromagnetic field coupling structure according to the invention is for use in a microwave band high frequency band. A microwave band frequency band as referred to herein specifically is a frequency band in a range of 10 GHz to 100 GHz.

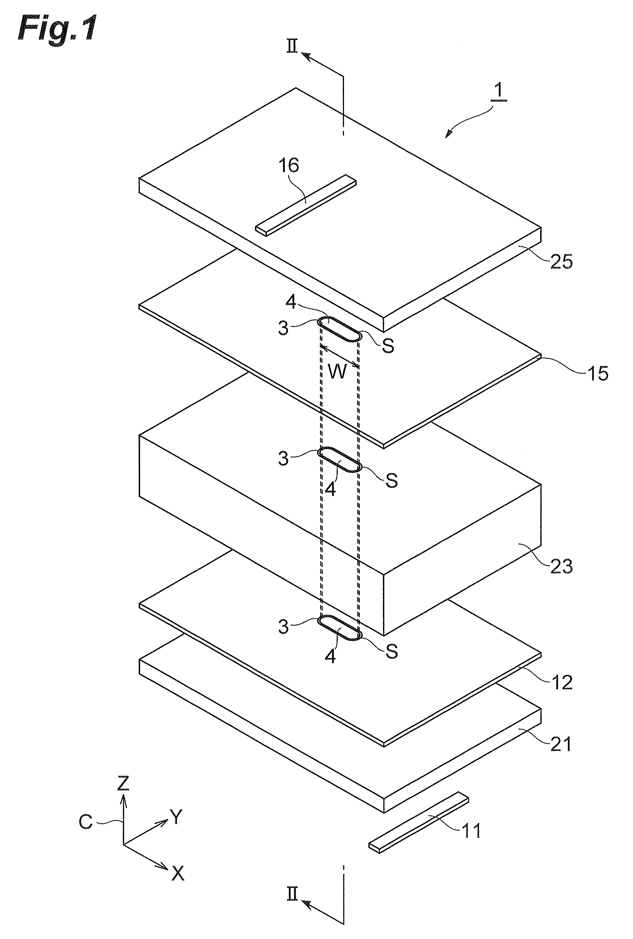

Fig. 1 is an exploded perspective view showing an embodiment of a multi-layer transmission-line plate having an electromagnetic field coupling structure related to this embodiment. As shown in Fig. 1, in a multi-layer transmission-line plate 1, a first conductor layer 11, a first dielectric layer 21, a second conductor layer 12, a second dielectric layer 23, a third conductor layer 15, a third dielectric layer 25, and a fourth conductor layer 16 are laminated in this order. Here, the second dielectric layer 23 is equivalent to an inner dielectric layer, the second conductor layer 12 and the third conductor layer 15 are equivalent to inner conductor layers which become a plurality of ground layers, the first dielectric layer 21 and the third dielectric layer 25 are equivalent to a pair of outer dielectric layers, and the first conductor layer 11 and the fourth conductor layer 16 are equivalent to a pair of outer conductor layers.

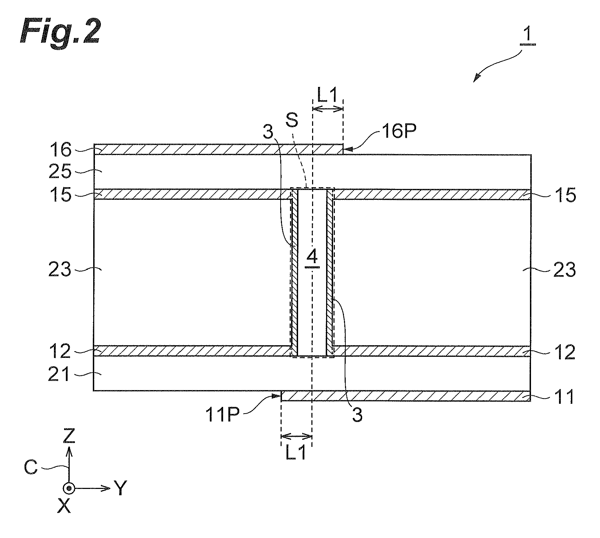

In Fig. 2, a cross-sectional configuration along line II-II that is a direction parallel to the extending directions of the first conductor layer 11 and the fourth conductor layer 16 in the multi-layer transmission-line plate 1 is shown. The first conductor layer 11 is a section which forms a first transmission line. Further, the fourth conductor layer 16 is a section which forms a second transmission line. The first transmission line and the second transmission line are high-frequency transmission lines which should be connected in an electromagnetic field manner.

The first conductor layer 11 which forms the first transmission line extends in the in-plane direction of the first dielectric layer 21. The fourth conductor layer 16 which forms the second transmission line extends in the in-plane direction of the third dielectric layer 25. In the example shown in Fig. 1 or 2, the first conductor layer 11 and the fourth conductor layer 16 extend with the Y direction as a long axis. In addition, the extending directions (the Y direction shown in Fig. 1 or 2) of the first conductor layer 11 and the fourth conductor layer 16 are orthogonal to a laminated direction (the Z direction shown in Fig. 1 or 2) of the first conductor layer 11, the first dielectric layer 21, the second conductor layer 12, the second dielectric layer 23, the third conductor layer 15, the third dielectric layer 25, and the fourth conductor layer 16.

The second conductor layer 12 and the third conductor layer 15 are ground conductors which form ground layers.

The first dielectric layer 21, the second dielectric layer 23, and the third dielectric layer 25 are sections for electrically isolating the first conductor layer 11, the second conductor layer 12, the third conductor layer 15, and the fourth conductor layer 16 from each other. Each of the first dielectric layer 21 and the third dielectric layer 25 is preferably made of a material having low dielectric loss and it is, for example, an insulating material such as ceramics, Teflon (registered trademark), polyphenylene ether, a modified product of polyphenylene ether, or a liquid crystal polymer. In addition, in the first dielectric layer 21 and the third dielectric layer 25, glass fibers may also be contained. If a low-loss material is used for the second dielectric layer 23, since a transmission-line plate becomes low loss as a whole, it is preferable. However, since it does not affect the loss of an electromagnetic field coupling structure, in consideration of the cost, an FR-4 level of a normal epoxy substrate or the like may also be used. In addition, in the second dielectric layer 23, glass fibers may also be contained.

In the multi-layer transmission-line plate 1, a hole S which penetrates the second conductor layer 12, the second dielectric layer 23, and the third conductor layer 15 is provided. The hole S that is a through-hole is provided in an area where the first conductor layer 11 which forms the first transmission line and the fourth conductor layer 16 which forms the second transmission line face each other. On an inner wall of the hole S, a tubular metal film 3 is formed by plating (for example, non-electrolytic plating). Therefore, since the second conductor layer 12 and the third conductor layer 15 are electrically connected via the tubular metal film 3, the first conductor layer 11 which forms the first transmission line and the fourth conductor layer 16 which forms the second transmission line are electromagnetically coupled. In addition, it is preferable that the tubular metal film 3 be formed over the entire surface of the inner wall of the hole S. However, a hole having a size of less than 1/4 of an effective wavelength λ corresponding to a frequency which is used may also be present in the tubular metal film 3.

It is preferable that the hole S with the tubular metal film 3 formed therein be filled with a dielectric 4 having a low dielectric loss tangent or a dielectric 4 having a high relative permittivity. In this embodiment, it is preferable to use the dielectric 4 in which a dielectric loss tangent at 10 GHz is in a range of 0 to 0.0300 or the dielectric 4 in which a relative permittivity at 10 GHz is in a range of 2 to 30. The dielectric 4 may also be a dielectric which satisfies both the dielectric loss tangent and the relative permittivity described above. Since transmission loss increases in proportion to the dielectric loss tangent of a material, transmission loss can be suppressed by filling the hole S with a material having a low dielectric loss tangent. Further, since the wavelength of a signal passing through the inside of the hole S is shortened by filling the hole with the dielectric 4 having a high relative permittivity, the width of the hole S also becomes narrow according to this, so that the higher densification of the electromagnetic field coupling structure becomes possible and it also leads to a reduction in drilling cost. At this time, if the relative permittivity of the dielectric 4 which is filled in the hole S becomes large, transmission loss increases. However, both the higher densification and the suppression of transmission loss can be achieved by filling the hole S with the dielectric 4 having a low dielectric loss tangent.

Further, in the example shown in Fig. 1, the cross section of the hole S cut so as to be parallel to the X-Y plane has a shape in which at both ends of a band-like portion extending in the X direction, semicircular portions are provided so as to protrude toward the outside of the band-like portion. A width W of the hole S in a direction (the X direction) orthogonal to the extending directions (the Y direction shown in Fig. 1) of the first conductor layer 11 and the fourth conductor layer 16 is set so as to become equal to or less than the effective wavelength λ corresponding to a frequency which is used in the multi-layer transmission-line plate 1. By setting the width W of the hole S in this manner, it is possible to achieve high-density integration of the electromagnetic field coupling structure while suppressing transmission loss.

Further, as shown in Fig. 2, the first conductor layer 11 which forms the first transmission line has an open end 11P at one end portion and the fourth conductor layer 16 which forms the second transmission line has an open end 16P at one end portion. A distance L1 from the center (a midst portion of the length of the hole S in the extending direction (the Y-axis direction) of the first conductor layer 11 which forms the first transmission line) of the hole S to the open end 11P or the open end 16P is set so as to approximately become about 1/4 of the effective wavelength λ described above. Transmission loss can be suppressed by such a configuration. In addition, if an additional remark is made as a precautionary measure, the first conductor layer 11 which forms the first transmission line and the fourth conductor layer 16 which forms the second transmission line may also have configurations extending toward the hole S from the same direction.

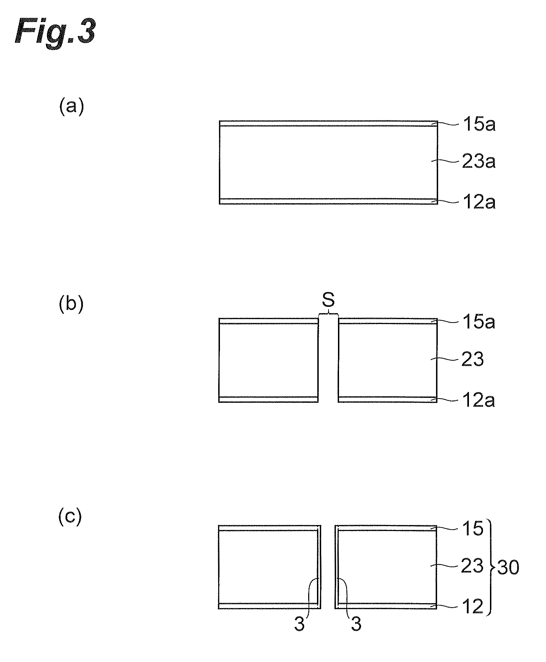

An example of a method of manufacturing the multi-layer transmission-line plate 1 is shown below. First, as shown in Fig. 3(a), a laminated body in which conductor layers 12a and 15a such as copper foil are formed on both sides of a dielectric layer 23a is prepared. Subsequently, as shown in Fig. 3(b), by perforating the laminated body with a drill or the like, the dielectric layer 23 having the conductor layers 12a and 15a on both sides and also having the hole S is formed. Subsequently, the tubular metal film 3 is formed on the inner wall of the hole S by plating. For example, as shown in Fig. 3(c), by performing a non-electrolytic plating treatment on the laminated body with the hole S formed therein, the tubular metal film 3 is formed on the inner wall of the hole S and the conductor layers 12 and 15 thicker than the conductor layers 12a and 15a shown in Fig. 3(b) are also formed on both sides of the dielectric layer 23. In this way, as shown in Fig. 3(c), a laminated body 30 is obtained in which the tubular metal film 3 is formed on the inner wall of the hole S that penetrates the conductor layers 12 and 15 facing each other with the dielectric layer 23 interposed therebetween. In addition, it is preferable that the thickness of the tubular metal film 3 be equal to or greater than 5 µm and equal to or less than 50 µm, and it is more preferable that the thickness be equal to or greater than 10 µm and equal to or less than 50 µm. If the thickness of the tubular metal film 3 is less than 5 µm, there is a concern that the tubular metal film may not be formed uniformly. It is also possible to form the tubular metal film 3 by vapor deposition or sputtering other than plating. However, in order to efficiently and uniformly obtain the above-described thickness, it is preferable to form the tubular metal film 3 by plating.

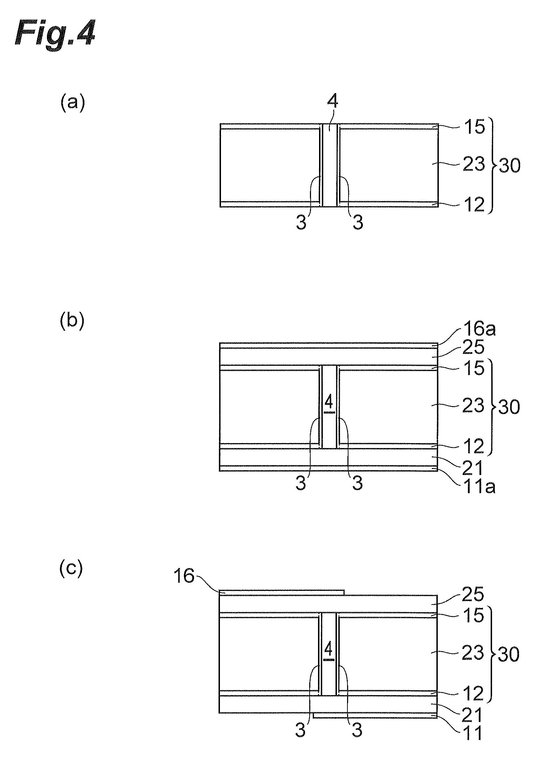

After the plating treatment, the hole S with the tubular metal film 3 formed therein is filled with the dielectric 4. As shown in Fig. 4(a), the surfaces of the dielectric 4 are polished and planarized. Subsequently, as shown in Fig. 4(b), after the pair of dielectric layers 21 and 25 is disposed to face each other with the laminated body 30 interposed therebetween and conductor layers 11a and 16a are further disposed to face each other with the dielectric layers 21 and 25 interposed therebetween, heating and crimping are performed. In this way, a structure body can be obtained in which the conductor layer 11a, the dielectric layer 21, the conductor layer 12, the dielectric layer 23, the conductor layer 15, the dielectric layer 25, and the conductor layer 16a are laminated in this order. Finally, by patterning the conductor layers 11 a and 16a by, for example, etching, the conductor layers 11 and 16 which form transmission lines are formed at positions facing each other with the hole S interposed therebetween, as shown in Fig. 4(c). In the way as described above, the multi-layer transmission-line plate 1 having the electromagnetic field coupling structure shown in Figs. 1 and 2 is obtained.

In the multi-layer transmission-line plate 1 having the electromagnetic field coupling structure as described above, the tubular metal film 3 electrically connecting the second conductor layer 12 and the third conductor layer 15 is provided on the inner wall of the hole S which penetrate the second conductor layer 12, the second dielectric layer 23, and the third conductor layer 15. For this reason, the first conductor layer 11 which forms the first transmission line and the fourth conductor layer 16 which forms the second transmission line are electromagnetically coupled via the first dielectric layer 21, the tubular metal film formed on the inner wall of the hole S, and the third dielectric layer 25. Therefore, it is possible to make the distance with a circuit or wiring adjacent to the hole S shorter than in the related art, so that the multi-layer transmission-line plate 1 in which the electromagnetic field coupling structure can be integrated in higher density can be provided.

Further, in the multi-layer transmission-line plate 1 as described above, transmission loss is small. The reason for this is that as shown in Fig. 2, in the multi-layer transmission-line plate 1, electromagnetic field modes over the first conductor layer 11 and the fourth conductor layer 16 which form transmission lines are in a "mirror image" relationship with the laminated body of the second conductor layer 12 and the third conductor layer 15 which form ground layers and the tubular metal film 3 electrically connecting the second conductor layer 12 and the third conductor layer 15, interposed therebetween. That is, the laminated body is disposed at the center in the laminated direction of the multi-layer transmission-line plate 1, which is the center position of the mirror image phenomenon of the transmission line. An electromagnetic field is stabilized and strong mode coupling can be obtained as a result of this configuration, and thus transmission loss is suppressed.

The multi-layer transmission-line plate 1 having the electromagnetic field coupling structure in this embodiment has been described above. However, the invention is not limited thereto. Above, an example of the laminated body in which the inner dielectric layer is sandwiched and laminated between the inner conductor layers which become a plurality of ground layers. However, the form of the laminated body is not limited thereto. For example, in such a laminated body, in addition to the inner dielectric layer, a conductor layer which does not become a ground layer may also be present. In this case, for example, a structure is obtained in which a conductor layer which does not become a ground layer and an inner dielectric layer are sandwiched between inner dielectric layers which become ground layers. Further, for example, it is possible to make the inside of the hole S with the tubular metal film 3 formed therein have, for example, an air layer other than epoxy resin or cyanate ester resin, as a dielectric. Since air is low in both the permittivity and the dielectric loss tangent, the transmission loss of the multi-layer transmission-line plate 1 is suppressed. Further, it is preferable that the cross-sectional shape of the hole S be a shape composed of the band-like portion and the semicircular portions as described above. However, it is not limited to this shape and may also be, for example, a circular shape, a rectangular shape, or the like.

Further, as a specific structure for realizing the above-described electromagnetic field coupling structure, it is preferable that the thickness of the second dielectric layer 23 be equal to or greater than 0.02 mm and equal to or less than 4 mm and it is more preferable that the thickness be equal to or greater than 0.02 mm and equal to or less than 2 mm. It is preferable that the surface on the first dielectric layer 21 side of the second conductor layer 12 and the surface on the third dielectric layer 25 side of the third conductor layer 15 be small in surface roughness in consideration of a skin effect, and it is preferable that the surface roughness (ten-point average roughness: Rz) be equal to or greater than 0.1 µm and equal to or less than 9 µm, it is more preferable that the surface roughness be equal to or greater than 0.1 µm and equal to or less than 6 µm, and it is further preferable that the surface roughness be equal to or greater than 0.1 µm and less than 3 µm.

Further, it is preferable that the thickness of each of the second conductor layer 12 and the third conductor layer 15 be equal to or greater than 5 µm and equal to or less than 50 µm and it is more preferable that the thickness be equal to or greater than 12 µm and equal to or less than 50 µm. As a material for obtaining such a structure, as long as it is a general multi-layer wiring board material, there is no particular problem, and a ceramic-based or organic wiring board material can be used. In order to obtain an inexpensive multi-layer transmission-line plate 1, in a wiring layer in which a high-frequency signal does not flow, a versatile multi-layer wiring board material can be used. Therefore, as the second conductor layer 12, the second dielectric layer 23, and the third conductor layer 15, for example, MCL-E-679 (trade name, manufactured by Hitachi Chemical Co., Ltd.) or the like which is a double-sided copper-clad laminated plate can be applied.

Further, in order to suppress transmission loss of a transmission line in which a high-frequency signal flows, a wiring board material having a low permittivity and a low dielectric loss tangent is preferable. For example, as the first dielectric layer 21 or the third dielectric layer 25, a double-sided copper-clad laminated plate, MCL-FX-2 (trade name, manufactured by Hitachi Chemical Co., Ltd.), or a prepreg, GFA-2 (trade name, manufactured by Hitachi Chemical Co., Ltd.), which is a low dielectric loss tangent and high heat resistance multilayer material, can be applied. It is more preferable that the thickness of the first dielectric layer 21 or the third dielectric layer 25 be equal to or greater than 0.02 mm and equal to or less than 0.8 mm and it is more preferable that the thickness be equal to or greater than 0.07 mm and equal to or less than 0.2 mm.

Further, with regard to copper foil which is used when fabricating the conductor layer 11 which forms the first transmission line or the conductor layer 16 which forms the second transmission line, it is preferable that the surface on the first dielectric layer 21 side of the first conductor layer 11 and the surface on the third dielectric layer 25 side of the fourth conductor layer 16 be small in surface roughness in consideration of a skin effect, and it is preferable that the surface roughness (Rz) be equal to or greater than 0.1 µm and equal to or less than 9 µm, it is more preferable that the surface roughness be equal to or greater than 0.1 µm and equal to or less than 6 µm, and it is further preferable that the surface roughness be equal to or greater than 0.1 µm and less than 3 µm. It is preferable that the thickness of each of the conductor layer 11 which forms the first transmission line or the conductor layer 16 which forms the second transmission line be equal to or greater than 5 µm and equal to or less than 50 µm and it is more preferable that the thickness be equal to or greater than 12 µm and equal to or less than 50 µm. As such a material, there is, for example, 3EC-VLP-12 (trade name, manufactured by Mitsui Mining & Smelting Co., Ltd.) or the like.

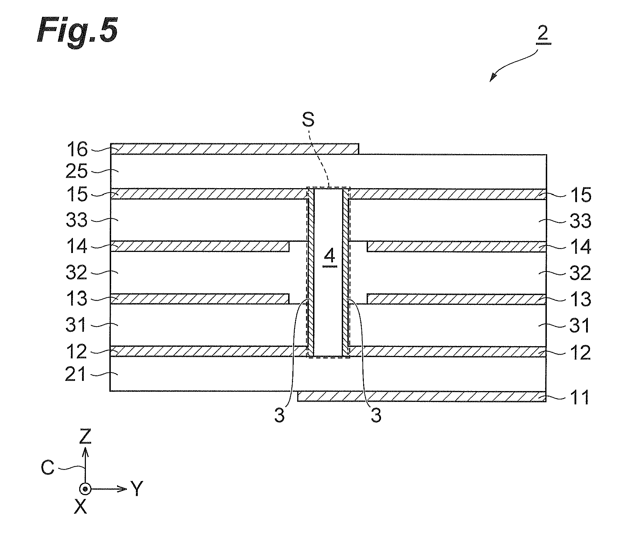

Further, in the above, an example has been shown in which the conductor layers are a total of four layers; the first conductor layer 11, the second conductor layer 12, the third conductor layer 15, and the fourth conductor layer 16. However, it is possible to make the conductor layers be four layers or more. For example, as shown in Fig. 5, it is possible to make the conductor layers be six layers. A multi-layer transmission-line plate 2 shown in Fig. 5 is different from the multi-layer transmission-line plate 1 shown in Fig. 2 in that a fifth conductor layer 13 and a sixth conductor layer 14 which become signal lines are further provided between the second conductor layer 12 and the third conductor layer 15 which become ground layers and dielectric layers 31, 32, and 33 for insulation between the second conductor layer 12, the fifth conductor layer 13, the sixth conductor layer 14, and the third conductor layer 15 are provided.

Here, the fifth conductor layer 13 and the sixth conductor layer 14 are sections which form inner layer signal lines. As shown in Fig. 5, the fifth conductor layer 13 and the sixth conductor layer 14 are insulated from the tubular metal film 3 formed on the inner wall of the hole S by the dielectric layers 31, 32, and 33. In this manner, the multi-layer transmission-line plate 2 includes a laminated body in which the plurality of inner dielectric layers 31, 32, and 33 and the plurality of conductor layers 12, 13, 14, and 15 are alternately laminated (here, the second conductor layer 12 and the third conductor layer 15 are equivalent to the inner conductor layers which become ground layers), the pair of outer dielectric layers 21 and 25 facing each other with the laminated body interposed therebetween, and the pair of outer conductor layers 11 and 16 facing each other with the pair of outer dielectric layers 21 and 25 interposed therebetween. On the inner wall of the hole S which penetrates all layers of the plurality of inner dielectric layers 31, 32, and 33 and the plurality of conductor layers 12, 13, 14, and 15 in the laminated body, the tubular metal film 3 is formed. Therefore, the multi-layer transmission-line plate 2 has an electromagnetic field coupling structure in which the pair of outer conductor layers 11 and 16 which forms transmission lines is electromagnetically coupled via the first dielectric layer 21, the tubular metal film 3, and the third dielectric layer 25. Therefore, similarly to the above-described embodiment, it is possible to make the distance with a circuit or wiring adjacent to the hole S shorter than in the related art, so that a higher density multi-layer transmission-line plate can be provided.

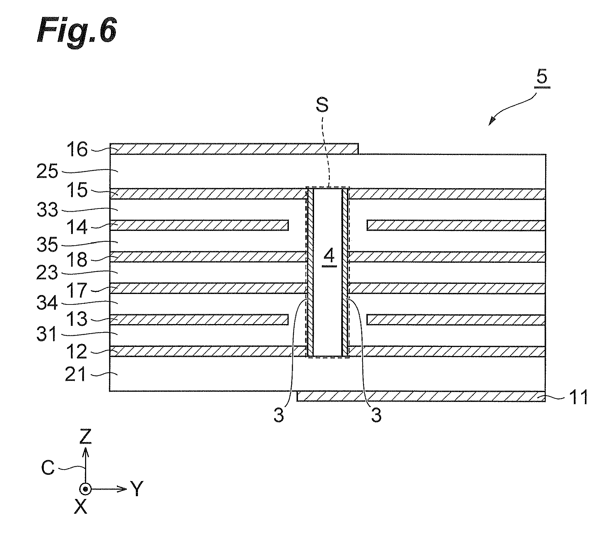

In the example shown in Fig. 5, an example has been described in which a plurality of conductor layers which become signal lines is provided between the second conductor layer 12 and the third conductor layer 15 on the inside, which become ground layers. However, inner conductor layers which become ground layers can be further provided between layers which become signal layers. For example, as shown in Fig. 6, it is possible to make the inner conductor layers and the outer conductor layers be eight layers in total. A multi-layer transmission-line plate 5 shown in Fig. 6 is different from the multi-layer transmission-line plate 2 shown in Fig. 5 in that a seventh conductor layer 17 and an eighth conductor layer 18 as inner conductor layers which become ground layers are further provided between the fifth conductor layer 13 and the sixth conductor layer 14 and inner dielectric layers 34, 23, and 35 for insulation between the fifth conductor layer 13, the sixth conductor layer 14, the seventh conductor layer 17, and the eighth conductor layer 18 are provided. As shown in Fig. 6, the seventh conductor layer 17 and the eighth conductor layer 18 which become ground layers are electrically connected to the tubular metal film 3 formed on the inner wall of the hole S. According to such a configuration, it is possible to pass more signal lines than the structure shown in Fig. 1. Further, compared to the structure shown in Fig. 5, since the seventh conductor layer 17 and the eighth conductor layer 18 which become ground layers are provided between the fifth conductor layer 13 and the sixth conductor layer 14, whereby there is no influence of cross-talk between signal lines which are in an upper layer or a lower layer, nor influence of variation in impedance, it is preferable.

In this manner, the multi-layer transmission-line plate 5 includes a laminated body in which the plurality of inner dielectric layers 31, 34, 23, 35, and 33 and the plurality of conductor layers 12, 13, 17, 18, 14, and 15 are alternately laminated (of these, the conductor layers 12, 17, 18, and 15 are equivalent to the inner conductor layers which become ground layers), the pair of outer dielectric layers 21 and 25 facing each other with the laminated body interposed therebetween, and the pair of outer conductor layers 11 and 16 facing each other with the pair of outer dielectric layers 21 and 25 interposed therebetween. On the inner wall of the hole S which penetrates all layers of the plurality of inner dielectric layers 31, 34, 23, 35, and 33 and the plurality of conductor layers 12, 13, 17, 18, 14, and 15 in the laminated body, the tubular metal film 3 is formed. Therefore, the multi-layer transmission-line plate 5 has an electromagnetic field coupling structure in which the pair of outer conductor layers 11 and 16 which form transmission lines is electromagnetically coupled via the first dielectric layer 21, the tubular metal film 3, and the third dielectric layer 25. Therefore, similarly to the above-described embodiment, it is possible to make the distance with a circuit or wiring adjacent to the hole S shorter than in the related art, so that a higher density multi-layer transmission-line plate can be provided.

The multi-layer transmission-line plate 5 described above can be manufactured by, for example, the following method. First, as the seventh copper layer 17, the second dielectric layer 23, and the eighth conductor layers 18, a double-sided copper-clad laminated plate a is prepared. Subsequently, on both sides of the laminated plate a, as the second conductor layer 12, the fourth dielectric layer 31, and the fifth conductor layer 13, a double-sided copper-clad laminated plate b is prepared and as the third conductor layer 15, the fifth dielectric layer 33, and the sixth conductor layer 14, a double-sided copper-clad laminated plate c is also prepared. In the fifth conductor layer 13 of the double-sided copper-clad laminated plate b and the sixth conductor layer 14 of the double-sided copper-clad laminated plate c, signal lines are formed in advance by removing a portion of each conductor in a larger size than the hole S by etching or the like. Subsequently, as the sixth dielectric layer 34 and the seventh dielectric layer 35, prepregs are respectively placed on the outsides of the double-sided copper-clad laminated plate a. Further, placement is performed such that the fifth conductor layer 13 side of the double-sided copper-clad laminated plate b and the sixth conductor layer 14 side of the double-sided copper-clad laminated plate c face the double-sided copper-clad laminated plate a side. Thereafter, after a laminated body is formed by heating and pressurization, the hole S is provided by a drill or the like. Thereafter, by plating the inner wall of the hole S by, for example, non-electrolytic copper plating, the inner conductor layers (that is, the second conductor layer 12, the seventh conductor layer 17, the eighth conductor layer 18, and the third conductor layer 15) are electrically connected.

Further, as a pair of outer dielectric layers (that is, the first dielectric layer 21 and the third dielectric layer 25), prepregs are respectively placed on the outsides of the laminated body. Further, on the outsides thereof, as a pair of outer conductor layers (that is, the first conductor layer 11 and the fourth conductor layer 16), copper foils are respectively placed. Thereafter, after heating and pressurization, by removing a portion of each of the first conductor layer 11 and the fourth conductor layer 16 by etching or the like, transmission line layers are formed.

In addition, in Figs. 5 and 6, a case where the outermost layers of the laminated body are conductor layers is shown. However, a conductor layer need not be provided necessarily at the outermost layer and the outermost layer may also be a dielectric layer. Further, dielectric layers and conductor layers need not be necessarily provided alternately and a plurality of dielectric layers may also be provided repeatedly or a plurality of conductor layers may also be piled up.

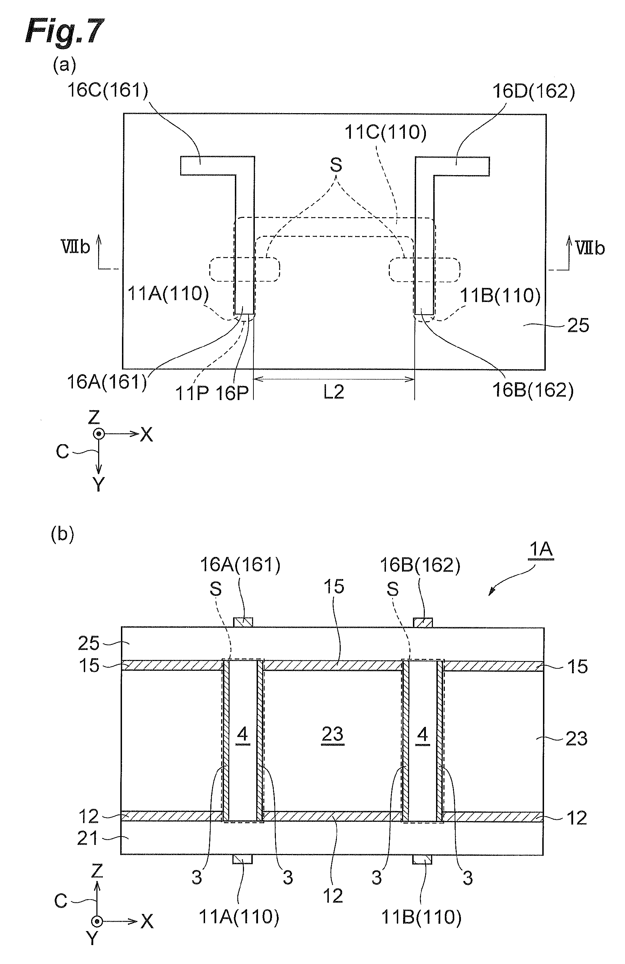

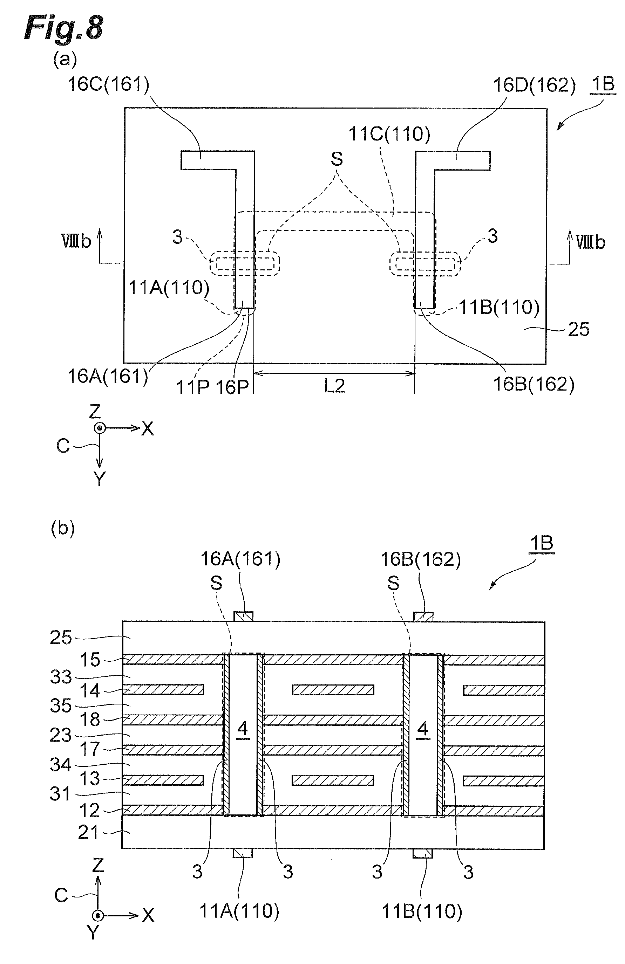

Hereinafter, Examples 1 to 4 and Comparative Examples 1 and 2 will be described. However, the invention is not limited to the following examples. In Examples 1 to 4 and Comparative Examples 1 and 2, the measurement of the transmission loss of the electromagnetic field coupling structure in a case where a frequency band is in a range of 60 GHz to 80 GHz was performed. Here, in the electromagnetic field coupling structure described above, since wirings (that is, the first conductor layer 11 and the fourth conductor layer 16) are divided into the front surface and the rear surface of the multi-layer transmission-line plate, it is difficult to perform high-frequency measurement just as it is by using a wafer prober or the like. For this reason, in the following Examples 1 to 4, as shown in Fig. 7(a) or 8(a), a multi-layer transmission-line plate 1A in which two fourth conductor layers 161 and 162 were used in place of a single fourth conductor layer 16 and two holes S was used in place of a single hole S was prepared. By connecting in series two slot couplings in this manner, it was made it possible to perform measurement by probing. In addition, in order to perform measurement by making probes face each other at the time of high-frequency measurement, the shape of the fourth conductor layer 161 on one side was made to be an L-shape composed of a long side 16A and a short side 16C and the shape of the fourth conductor layer 162 on one side was also made to be an L-shape composed of a long side 16B and a short side 16D. The short side 16C and the short side 16D were used as terminal connection sections at the time of probing measurement. Further, as a substitute for the first conductor layer 11, a U-shaped first conductor layer 110 composed of one end 11A, the other end 11B, and a connection portion 11C connecting the one end 11A and the other end 11B was used.

### (Example 1)

Fig. 7(a) is a top perspective diagram when the multi-layer transmission-line plate 1A is viewed from the fourth conductor layers 161 and 162 side. Fig. 7(b) is a cross-sectional view along line VIIb-VIIb of Fig. 7(a). In Example 1, the multi-layer transmission-line plate 1A was fabricated in which a transmission line (the first conductor layer 110), the first dielectric layer 21, the second conductor layer 12, the second dielectric layer 23, the third conductor layer 15, the third dielectric layer 25, and two transmission lines (the fourth conductor layer 161 and the fourth conductor layer 162) are laminated in this order. As shown in Fig. 7(b), as transmission lines equivalent to outer conductor layers, the first conductor layer 110 and the fourth conductor layer 161 were disposed to face each other at positions corresponding to the hole S on one side formed in an inner layer circuit board, and as transmission lines equivalent to outer conductor layers, the first conductor layer 110 and the fourth conductor layer 162 were also disposed to face each other at positions corresponding to the hole S on the other side. In addition, the expression "being disposed to face each other" as referred to herein means that disposition is performed such that the center of the hole S (the midst portion of the length of the hole S in the extending direction (the Y-axis direction) of the fourth conductor layer 16 which forms the second transmission line) is aligned with a point on the conductor layer on the inside by approximately 1/4 of the effective wavelength λ from the open end 11P of the first conductor layer 110 or the open end 16P of the fourth conductor layer 161 or 162.

At this time, the fourth conductor layer 161 and the fourth conductor layer 162 were disposed in such a manner that the long side 16A of the fourth conductor layer 161 and the long side 16B of the fourth conductor layer 162 face each other at a given interval in the vicinity of the center of the multi-layer transmission-line plate 1A. Further, the extending direction (in the example shown in Fig. 7(a), the Y-axis direction) of each of the long side 16A of the fourth conductor layer 161 and one end 11A of the first conductor layer 110 was disposed in a direction orthogonal to a long axis direction of the hole S on one side. Similarly, the extending directions (in the example shown in Fig. 7(a), the Y-axis direction) of the long side 16B of the fourth conductor layer 162 and the other end 11B of the first conductor layer 110 was disposed in a direction orthogonal to the long axis direction of the hole S on the other side. The second conductor layer 12 and the third conductor layer 15 were electrically connected via the tubular metal film 3 formed on the inner wall of each of the two holes S. Therefore, an electromagnetic field coupling structure 100 was formed in which via the first dielectric layer 21, the tubular metal film 3, and the third dielectric layer 25, the first conductor layer 110 that is a transmission line is electromagnetically coupled to the fourth conductor later 161 and the first conductor layer 110 that is a transmission line is also electromagnetically coupled to the fourth conductor later 162.

A specific manufacturing method of the multi-layer transmission-line plate 1A will be described below. First, a laminated plate (trade name: MCL-E-679 manufactured by Hitachi Chemical Co., Ltd.) in which copper foils (which become the second conductor layer 12 and the third conductor layer 15) are formed on both sides of a dielectric layer (which becomes the second dielectric layer 23) was prepared. The thickness of the laminated plate was 0.5 mm, the thickness of each copper foil was 12 µm, and the surface roughness Rz on the dielectric layer side was 6.0 µm. Subsequently, the two holes S were formed by forming holes each having a diameter of 0.25 mm and a width W of 1.45 mm in the laminated body by using a drill having a diameter of 0.25 mm. After copper plating is performed by 10 µm on the inner walls of the two holes S and the surfaces of the copper foils, by printing hole filling resin (trade name: DX-1 manufactured by Taiyo Ink. Mfg. Co., Ltd., dielectric loss tangent at 10 GHz: 0.03 and relative permittivity: 3.5) equivalent to the dielectric 4, in each hole S, and polishing the surfaces, an inner layer circuit board was fabricated. In addition, in Fig. 7(b), the illustration of copper plated films on the surfaces of the copper foil which becomes the second conductor layer 12 and the copper foil which becomes the third conductor layer 15 is omitted.

Next, a multi-layer transmission-line plate was fabricated in which copper foil (trade name: 3EC-VLP-12 manufactured by Mitsui Mining & Smelting Co., Ltd., surface roughness Rz on the dielectric layer side: 3.0 µm) having a thickness of 12 µm, a prepreg (trade name: GFA-2 manufactured by Hitachi Chemical Co., Ltd., thickness: 100 µm), the above-described inner layer circuit board, a prepreg (trade name: GFA-2 manufactured by Hitachi Chemical Co., Ltd., thickness: 100 µm), and copper foil (trade name: 3EC-VLP-12 manufactured by Mitsui Mining & Smelting Co., Ltd., surface roughness Rz on the dielectric layer side: 3.0 µm) having a thickness of 12 µm were piled up in this order and laminated and integrated in the conditions of temperature 180°C, pressure 3 MPa, and time 80 minutes.

Finally, with respect to this multi-layer transmission-line plate, the upper and lower copper foils were patterned by etching. By patterning the upper copper foil, two L-shaped fourth conductor layers 161 and 162 were obtained. Further, by patterning the lower copper foil, a U-shaped first conductor layer 110 was obtained. At this time, as transmission lines each having a width of 220 µm, the long side 16A of the fourth conductor layer 161 and one end 11A of the first conductor layer 110 were disposed to face each other at positions corresponding to the hole S on one side formed in the inner layer circuit board and as transmission lines each having a width of 220 µm, the long side 16B of the fourth conductor layer 162 and the other end 11B of the first conductor layer 110 were also disposed to face each other at positions corresponding to the hole S on the other side.

These transmission lines (that is, the fourth conductor layer 161, the fourth conductor layer 162, and the first conductor layer 110) are microstrip lines, with characteristic impedance set to be 50 Ω. In the way as described above, the multi-layer transmission-line plate 1A having the electromagnetic field coupling structure 100 having the two holes S as shown in Figs. 7(a) and 7(b) was fabricated. Here, a shortest distance L2 from the inside of the long side 16A of the fourth conductor layer 161 on one side which is a transmission line to the inside of the long side 16B of the fourth conductor layer 162 on the other side was 1.63 mm.

### (Example 2)

In Example 1, as the dielectric 4 in each hole S, resin was printed in a hole filling manner. However, in Example, 2, a multi-layer transmission-line plate having an electromagnetic field coupling structure 101 having the two holes S as shown in Figs. 7(a) and 7(b) was fabricated by printing the dielectric 4 having relative permittivity of 2.8 and dielectric loss tangent of 0.003 at 10 GHz in each hole S in a hole filling manner and making the other conditions the same as those in Example 1. Here, the shortest distance L2 from the inside of the long side 16A of the fourth conductor layer 161 on one side which is a transmission line to the inside of the long side 16B of the fourth conductor layer 162 on the other side was 1.63 mm.

### (Example 3)

First, a laminated plate with copper foils formed on both sides of a dielectric layer (trade name: MCL-E-679 manufactured by Hitachi Chemical Co., Ltd.) was prepared. The thickness of the laminated plate was 0.5 mm, the thickness of each copper foil was 12 µm, and the surface roughness Rz on the dielectric layer side was 6.0 µm. Subsequently, the two holes S were formed by forming holes each having a diameter of 0.25 mm and a width W of 1.00 mm in the laminated body by using a drill having a diameter of 0.25 mm. After copper plating is performed to be 10 µm on the inner walls of the two holes S and the surfaces of the copper foils, by printing the dielectric 4 having relative permittivity of 15 and dielectric loss tangent of 0.03 at 10 GHz in each hole S and polishing the surfaces, an inner layer circuit board was fabricated. In addition, in Fig. 7(b), copper plated films on the surfaces of the copper foils 12 and 15 are omitted.

Next, a multi-layer transmission-line plate was fabricated in which copper foil (trade name: 3EC-VLP-12 manufactured by Mitsui Mining & Smelting Co., Ltd., surface roughness Rz on the dielectric layer side: 3.0 µm) having a thickness of 12 µm, a prepreg (trade name: GFA-2 manufactured by Hitachi Chemical Co., Ltd., thickness: 100 µm), the above-described inner layer circuit board, a prepreg (trade name: GFA-2 manufactured by Hitachi Chemical Co., Ltd., thickness: 100 µm), and copper foil (trade name: 3EC-VLP-12 manufactured by Mitsui Mining & Smelting Co., Ltd., surface roughness Rz on the dielectric layer side: 3.0 µm) having a thickness of 12 µm were piled up in this order and laminated and integrated in the conditions of temperature 180°C, pressure 3 MPa, and time 80 minutes.

Finally, with respect to this multi-layer transmission-line plate, by patterning the upper and lower copper foils by etching, at positions corresponding to the hole S on one side formed in the inner layer circuit board, the transmission lines 16A and 11A each having a width of 220 µm were disposed to face each other such that the extending direction of each of 16A and 11A becomes a direction orthogonal to the long axis direction of the hole S, and at positions corresponding to the hole S on the other side, the transmission lines 16B and 11 B each having a width of 220 µm were disposed to face each other such that the extending direction of each of 16B and 11B becomes a direction orthogonal to the long axis direction of the hole S.

The transmission lines 16A, 16B, and 110 are microstrip lines with characteristic impedance set to be 50 Q. In the way as described above, the multi-layer transmission-line plate 1 A having an electromagnetic field coupling structure 102 having the two holes S as shown in Figs. 7(a) and 7(b) was fabricated. To supplement, the multi-layer transmission-line plate 1A has the electromagnetic field coupling structure 102 in which the transmission line 110, the first dielectric layer 21, the second conductor layer 12, the second dielectric layer 23, the third conductor layer 15, the third dielectric layer 25, and the two transmission lines 16A and 16B are laminated in this order and the second conductor layer 12 and the third conductor layer 15 are electrically connected via the tubular metal film 3 formed on the inner wall in each of the two holes S, whereby via the first dielectric layer 21, the tubular metal film 3 formed on the inner wall of each of the two holes S, the third dielectric layer 25, the transmission line 11A and the transmission line 16A are electromagnetically coupled and the transmission line 11B and the transmission line 16B are also electromagnetically coupled. In addition, the transmission lines 16A, 168, and 110 are microstrip lines with characteristic impedance set to be 50 Ω. In the way as described above, the multi-layer transmission-line plate 1A having the electromagnetic field coupling structure 102 having the two holes S as shown in Figs. 7(a) and 7(b) was fabricated. Here, the shortest distance L2 from the inside of the long side 16A of the fourth conductor layer 161 on one side which is a transmission line to the inside of the long side 16B of the fourth conductor layer 162 on the other side was 1.18 mm.

### (Example 4)

In Example 4, an electromagnetic field coupling structure 103 was adopted in which each of a conductor layer which becomes a signal line layer and a conductor layer which becomes a ground layer is formed by two layers between the conductor layers of the laminated body in the transmission-line plate shown in Example 1 and a dielectric layer is interposed between the respective conductor layers.

In Figs. 8(a) and 8(b), a multi-layer transmission-line plate 1B having the electromagnetic field coupling structure 103 which includes the two holes S fabricated in Example 4 is shown. Fig. 8(a) is a top perspective diagram when the multi-layer transmission-line plate 1B is viewed from the fourth conductor layers 161 and 162 side. Fig. 8(b) is a cross-sectional view along line VIIIb-VIIIb of Fig. 8(a). The multi-layer transmission-line plate 1B has a structure in which the first conductor layer 110, the first dielectric layer 21, the second conductor layer 12, the fourth dielectric layer 31, the fifth conductor layer 13, the sixth dielectric layer 34, the seventh conductor layer 17, the second dielectric layer 23, the eighth conductor layer 18, the seventh dielectric layer 35, the sixth conductor layer 14, the fifth dielectric layer 33, the third conductor layer 15, the third dielectric layer 25, and the two fourth conductor layers 161 and 162 are laminated in this order.

As shown in Fig. 8(b), the two holes S were made to penetrate from the third conductor layer 15 to the second conductor layer 12. The tubular metal film 3 was formed on the inner wall of each hole S. Each hole S with the tubular metal film 3 formed on the inner wall was filled with the dielectric 4. The second conductor layer 12, the seventh conductor layer 17, the eighth conductor layer 18, and the third conductor layer 15, which become ground layers, are electrically connected by the metal film 3. Further, the fifth conductor layer 13 and the sixth conductor layer 14 which become signal line layers are not electrically connected to the metal film 3 formed in the hole S.

Further, as shown in Fig. 8(a), as transmission lines equivalent to the outer conductor layers, the first conductor layer 110 and the fourth conductor layer 161 were disposed to face each other at positions corresponding to the hole S on one side formed in an inner layer circuit board, and as transmission lines equivalent to the outer conductor layers, the first conductor layer 110 and the fourth conductor layer 162 were also disposed to face each other at positions corresponding to the hole S on the other side. At this time, the fourth conductor layer 161 and the fourth conductor layer 162 were disposed in such a manner that the long side 16A of the fourth conductor layer 161 and the long side 16B of the fourth conductor layer 162 face each other at a given interval in the vicinity of the center of the multi-layer transmission-line plate 1B. Further, the extending direction (in the example shown in Fig. 8(a), the Y-axis direction) of each of the long side 16A of the fourth conductor layer 161 and one end 11A of the first conductor layer 110 was disposed in a direction orthogonal to the long axis direction of the hole S on one side. Similarly, the extending direction (in the example shown in Fig. 8(a), the Y-axis direction) of each of the long side 16B of the fourth conductor layer 162 and the other end 11B of the first conductor layer 110 was disposed in a direction orthogonal to the long axis direction of the hole S on the other side. In the electromagnetic field coupling structure 103 as described above, the second conductor layer 12 and the third conductor layer 15 were electrically connected via the two metal films 3, whereby the first conductor layer 110 that is a transmission line is electromagnetically coupled to each of the fourth conductor layers 161 and 162 that are transmission lines, via the third dielectric layer 25, the two metal films 3, and the first dielectric layer 21.

A specific manufacturing method of the multi-layer transmission-line plate 1B will be described below.

First, a laminated plate with copper foils formed on both sides of a dielectric layer (trade name: MCL-E-679 manufactured by Hitachi Chemical Co., Ltd.) (a laminated plate 1) was prepared. The thickness of the laminated plate was 0.1 mm, the thickness of each copper foil was 12 µm, and the surface roughness Rz on the dielectric layer side was 6.0 µm. Subsequently, two sheets of double-sided copper-clad laminated plates (trade name: MCL-LX-67Y manufactured by Hitachi Chemical Co., Ltd.) each having a plate thickness of 0.1 mm and a copper foil thickness of 12 µm (laminated plates 2) were prepared. A place where a hole will be provided later, of the copper foil on one side of the two sheets of double-sided copper-clad laminated plates prepared is removed slightly larger (100 µm) by etching and a given transmission line was also formed by etching.

A laminated body was fabricated in which prepregs (trade name: GXA-67Y manufactured by Hitachi Chemical Co., Ltd., thickness: 100 µm) were placed on both sides of the laminated plate 1 and the laminated plates 2 were piled up on the outsides thereof with the transmission line side of the laminated plate 2 facing the laminated plate 1 side and laminated and integrated in the conditions of temperature 230°C, pressure 3 MPa, and time 80 minutes.

The two holes S were formed by forming holes each having a diameter of 0.25 mm and a width W of 1.45 mm in the laminated body by using a drill having a diameter of 0.25 mm. After the tubular metal films 3 are formed by performing copper plating to be 10 µm on the inner walls of the two holes S and the surfaces of the copper foils, by printing hole filling resin (trade name: DX-1 manufactured by Taiyo Ink. Mfg. Co., Ltd., dielectric loss tangent at 10 GHz: 0.03 and relative permittivity: 3.5) that is the dielectric 4, in each hole S, and polishing the surfaces, so that an inner layer circuit board was fabricated. In addition, in Fig. 8(b), copper plated films on the surfaces of the copper foils 12 and 15 are omitted.

Next, a multi-layer transmission-line plate 1B was fabricated in which copper foil (trade name: 3EC-VLP-12 manufactured by Mitsui Mining & Smelting Co., Ltd., surface roughness Rz on the dielectric layer side: 3.0 µm) having a thickness of 12 µm, a prepreg (trade name: GFA-2 manufactured by Hitachi Chemical Co., Ltd., thickness: 100 µm), the above-described inner layer circuit board, a prepreg (trade name: GFA-2 manufactured by Hitachi Chemical Co., Ltd., thickness: 100 µm), and copper foil (trade name: 3EC-VLP-12 manufactured by Mitsui Mining & Smelting Co., Ltd., surface roughness Rz on the dielectric layer side: 3.0 µm) having a thickness of 12 µm were piled up in this order and laminated and integrated in the conditions of temperature 180°C, pressure 3 MPa, and time 80 minutes.

Finally, with respect to this multi-layer transmission-line plate, the upper and lower copper foils were patterned by etching. By patterning the upper copper foil, two L-shaped fourth conductor layers 161 and 162 were obtained. Further, by patterning the lower copper foil, a U-shaped first conductor layer 110 was obtained. At this time, the long side 16A of the fourth conductor layer 161 and one end 11A of the first conductor layer 110, each of which has a width of 220 µm, were disposed to face each other at positions corresponding to the hole S on one side formed in the inner layer circuit board and the long side 16B of the fourth conductor layer 162 and the other end 11B of the first conductor layer 110, each of which has a width of 220 µm, were also disposed to face each other at positions corresponding to the hole S on the other side. Further, the extending direction (the Y-axis direction shown in Fig. 8(a)) of each of the long side 16A of the fourth conductor layer 161 and one end 11A of the first conductor layer 110 was disposed so as to become a direction orthogonal to the long axis direction (the X-axis direction) of the hole S on one side and the extending direction (the Y-axis direction) of each of the long side 16B of the fourth conductor layer 162 on the other side and the other end 11B of the first conductor layer 110 was also disposed so as to become a direction orthogonal to the long axis direction (the X-axis direction) of the hole S on the other side.

These transmission lines (the fourth conductor layers 161 and 162 and the first conductor 110) are microstrip lines with characteristic impedance set to be 50 Ω. In the way as described above, the multi-layer transmission-line plate 1B having an electromagnetic field coupling structure 103 having the two slots S as shown in Figs. 8(a) and 8(b) was fabricated. Here, the shortest distance L2 from the inside of the long side 16A of the fourth conductor layer 161 on one side which is a transmission line to the inside of the long side 16B of the fourth conductor layer 162 on the other side was 1.63 mm.

### (Comparative Example 1)

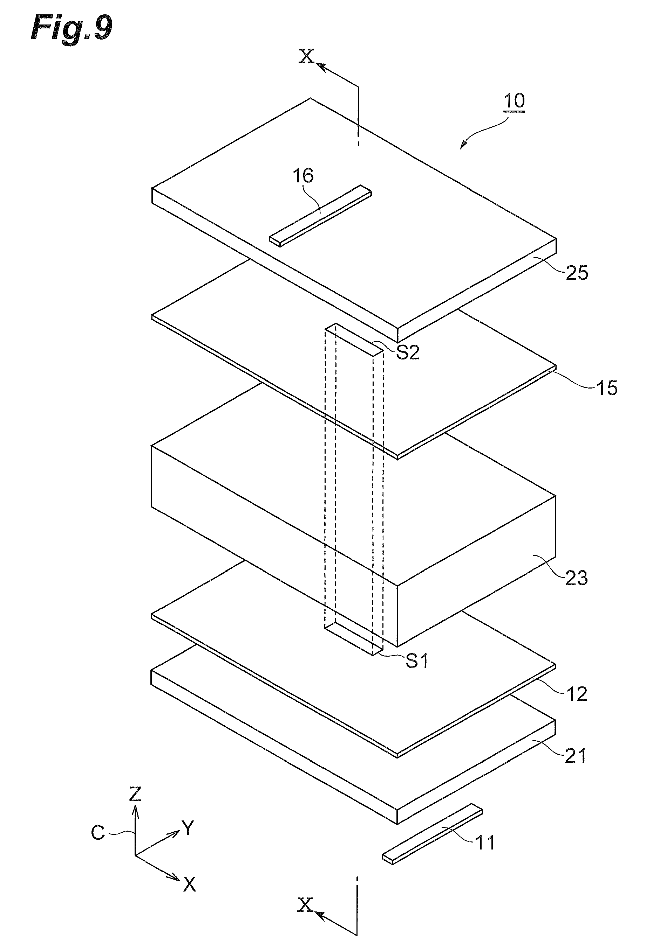

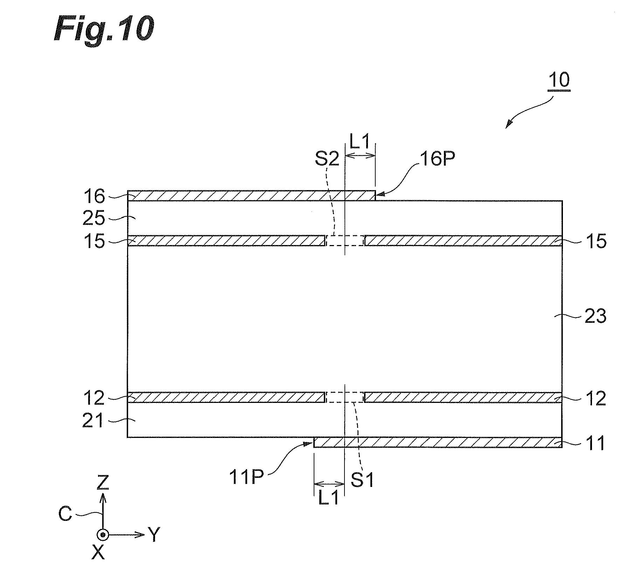

Fig. 9 shows an exploded perspective view of a multi-layer transmission-line plate 10 related to Comparative Example 1. Fig. 10 is a cross-sectional view along line X-X of Fig. 9. In Comparative Example 1, the configuration of the multi-layer transmission-line plate 10 having a slot S1 which penetrates only the second conductor layer 12 and a slot S2 which penetrates only the third conductor layer 15, as shown in Figs. 9 and 10, was adopted. Here, the slots are holes provided only in conductor layers. In the multi-layer transmission-line plate 10, the first conductor layer (a transmission line) 11, the first dielectric layer 21, the second conductor layer 12, the second dielectric layer 23, the third conductor layer 15, the third dielectric layer 25, and the fourth conductor layer (a transmission line) 16 are laminated in this order. The extending direction (the Y-axis direction) of the first conductor layer 11 was set to be the same as the extending direction (the Y-axis direction) of the fourth conductor layer 16. The long axis direction (the X-axis direction) of each of the slots S1 and S2 was made to be orthogonal to the extending direction (the Y-axis direction) of each transmission line. One end of the first conductor layer 11 was set to be an open end 11P and one end of the fourth conductor layer 16 was set to be an open end 16P. The distance L1 from the open end 11P of the first conductor layer 11 to the center of the slot S1 was set to be approximately 1/4 of the effective wavelength λ which is used. Similarly, the distance L1 from the open end 16P of the fourth conductor layer 16 to the center of the slot S2 was set to be about 1/4 of the effective wavelength λ which is used.

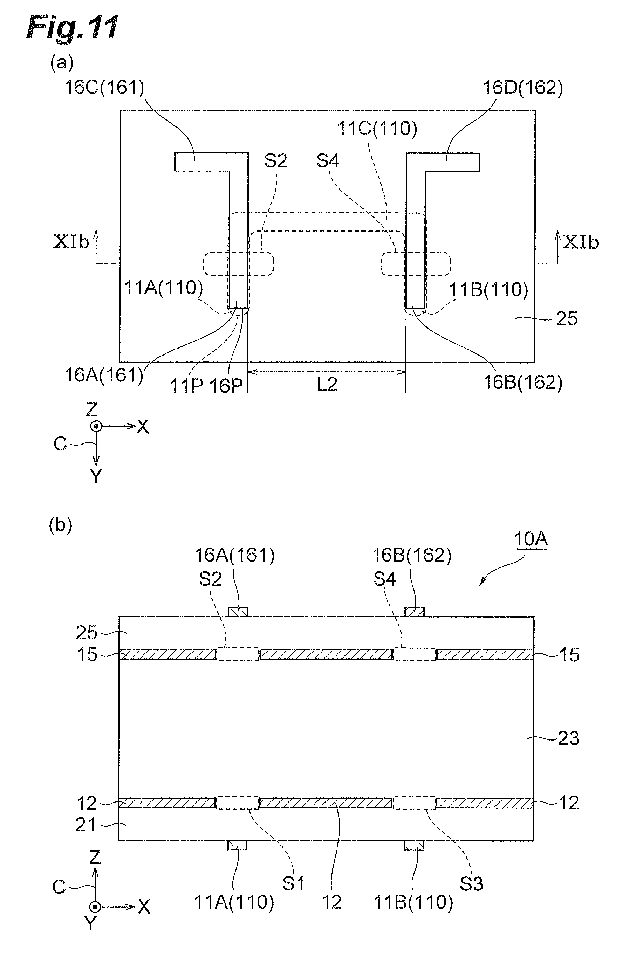

As shown in Fig. 10, in the multi-layer transmission-line plate 10 of Comparative Example 1, a hole penetrating the second dielectric layer 23 is not provided in the second dielectric layer 23. However, as described above, since wirings (that is, the first conductor layer 11 and the fourth conductor layer 16) are divided into the front and the rear of the multi-layer transmission-line plate 10, it is difficult to perform high-frequency measurement just as it is by using a wafer prober or the like. For this reason, in fact, a multi-layer transmission-line plate 10A was fabricated which adopts a configuration having two L-shaped transmission lines (that is, two fourth conductor layers 161 and 162) on the front surface and having a single U-shaped transmission (that is, the first conductor layer 110) on the rear surface, as shown in Figs. 11(a) and 11(b), similarly to Examples 1 to 4, and has four slots S1, S2, S3, and S4.

A specific manufacturing method of the multi-layer transmission-line plate 10A will be described below. First, a double-sided copper-clad laminated plate (trade name: MCL-E-679 manufactured by Hitachi Chemical Co., Ltd.) having a plate thickness of 0.5 mm and a copper foil thickness of 12 µm was prepared. The surface roughness Rz on the dielectric layer side of the copper foil was 6.0 µm. By patterning the copper foils by etching, an inner layer circuit board having the four slots S1, S2, S3, and S4 each having a size of major axis 1.9 mmxminor axis 0.4 mm was fabricated. The slot S1 and the slot S3 were formed so as to penetrate only the copper foil which becomes the second conductor layer 12 and the slot S2 and the slot S4 were formed so as to penetrate only the copper foil which becomes the third conductor layer 15. Further, when viewed from a laminated direction (the Z-axis direction), the slot S1 and the slot S2 were disposed to face each other so as to overlap each other and the slot S3 and the slot S4 were also disposed to face each other so as to overlap each other.

Next, a multi-layer transmission-line plate was fabricated in which copper foil (trade name: 3EC-VLP-12 manufactured by Mitsui Mining & Smelting Co., Ltd., surface roughness Rz on the dielectric layer side: 3.0 µm) having a thickness of 12 µm, a prepreg (trade name: GFA-2 manufactured by Hitachi Chemical Co., Ltd., thickness: 100 µm), the above-described inner layer circuit board, a prepreg (trade name: GFA-2 manufactured by Hitachi Chemical Co., Ltd., thickness: 100 µm), and copper foil (trade name: 3EC-VLP-12 manufactured by Mitsui Mining & Smelting Co., Ltd., surface roughness Rz on the dielectric layer side: 3.0 µm) having a thickness of 12 µm were piled up in this order and laminated and integrated in the conditions of temperature 180°C, pressure 3 MPa, and time 80 minutes.

Lastly, the upper and lower copper foils were patterned by etching. That is, by patterning the upper copper foil, two L-shaped fourth conductor layers 161 and 162 were obtained. Further, by patterning the lower copper foil, a U-shaped first conductor layer 110 was obtained. At this time, one end 11A of the first conductor layer 110 and the long side 16A of the fourth conductor layer 161, each of which has a width of 220 µm, were disposed to face each other at positions corresponding to the slots S1 and S2 formed in the inner layer circuit board and the extending direction (the Y-axis direction shown in Fig. 11(a)) of each of one end 11 A of the first conductor layer 110 and the long side 16A of the fourth conductor layer 161 was also set to be a direction orthogonal to the long axis direction (the X-axis direction) of the slot S1 or the slot S2. Similarly, the other end 11B of the first conductor layer 110 and the long side 16B of the fourth conductor layer 162, each of which has a width of 220 µm, were disposed to face each other at positions corresponding to the slots S3 and S4 and the extending direction (the Y-axis direction shown in Fig. 11 (a)) of each of the other end 11B of the first conductor layer 110 and the long side 16B of the fourth conductor layer 162 was also set to be a direction orthogonal to the long axis direction (the X-axis direction) of the slot S3 or the slot S4. To supplement, the multi-layer transmission-line plate 10A has an electromagnetic field coupling structure 1000 in which the first conductor layer 110 (which is a transmission line), the first dielectric layer 21, the second conductor layer 12, the second dielectric layer 23, the third conductor layer 15, the third dielectric layer 25, and the fourth conductor layers 161 and 162 (which are two transmission lines) are laminated in this order, the first conductor layer 110 that is a transmission line is electromagnetically coupled to the fourth conductor layer 161 via the slot S1 and the slot S2, and the first conductor layer 110 that is a transmission line is also electromagnetically coupled to the fourth conductor layer 162 via the slot S3 and the slot S4. In addition, the first conductor layer 110 and the fourth conductor layers 161 and 162, which are transmission lines, are microstrip lines with characteristic impedance set to be 50 Ω. In the way as described above, the multi-layer transmission-line plate 10A having the electromagnetic field coupling structure 1000 having the four slots S1, S2, S3, and S4 as shown in Fig. 11(b) was fabricated. Here, the shortest distance L2 from the inside of the long side 16A of the fourth conductor layer 161 on one side which is a transmission line to the inside of the long side 16B of the fourth conductor layer 162 on the other side was 2.08 mm.

### (Comparative Example 2)

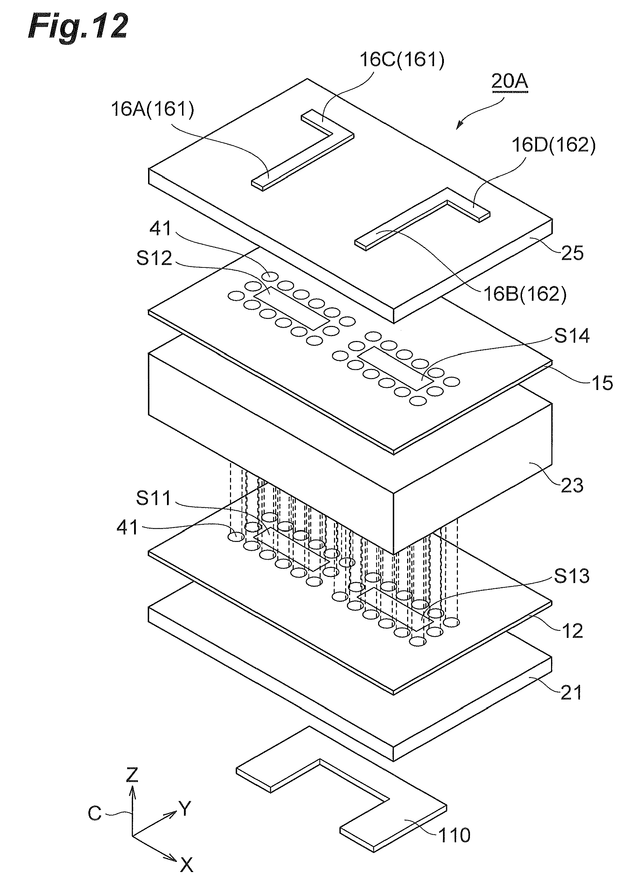

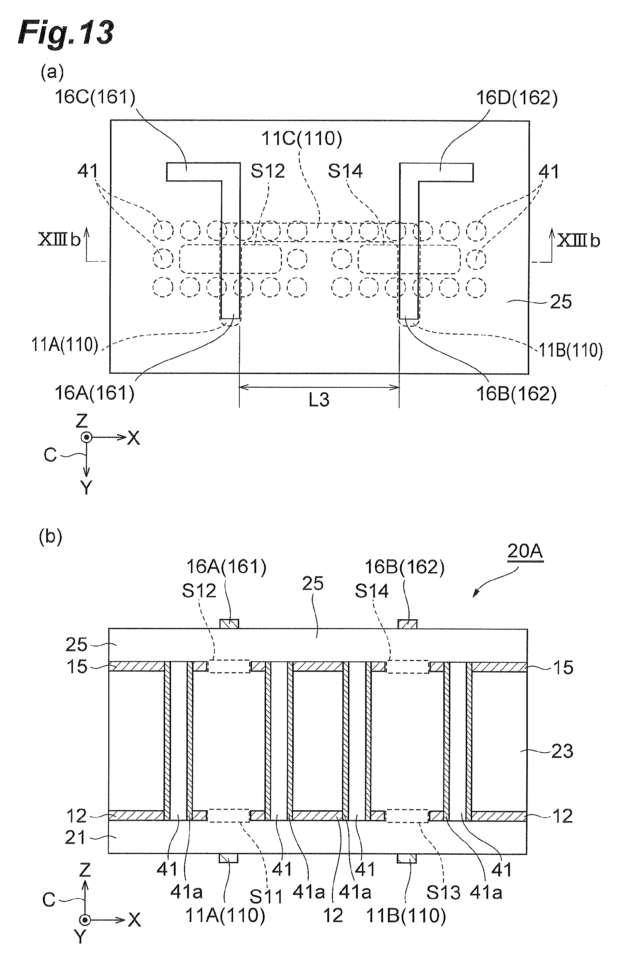

In Comparative Example 2, a structure equivalent to Example 1 of Patent Literature 1 was adopted. A specific structure is shown in Figs. 12, 13(a), and 13(b). Fig. 12 shows an exploded perspective view of a multi-layer transmission-line plate 20A used in high-frequency measurement in Comparative Example 2. Fig. 13(a) is a top perspective diagram when the multi-layer transmission-line plate of Fig. 12 is viewed from the upper outer conductor layer side. Fig. 13(b) is a cross-sectional view along line XIIIb-XIIIb of Fig. 13(a). In addition, in order to perform measurement by making probes face each other at the time of high-frequency measurement, similarly to Examples 1 to 4, the fourth conductor layer was set to be two and each of the fourth conductor layers 161 and the fourth conductor layers 162 was made to be an L-shape. The long side 16A of the fourth conductor layer 161 was disposed parallel to the long side 16B of the fourth conductor layer 162 on the third conductor layer 25. Further, the short side 16C of the fourth conductor layer 161 and the short side 16D of the fourth conductor layer 162 were used as terminal connection sections for probing. As shown in Fig. 12, slots S12 and S14 which penetrate only the third conductor layer 15 provided across the dielectric layer 25 were formed below the fourth conductor layers 161 and 162 that are transmission lines. As shown in Fig. 12 or 13(a), the long axis directions (the X-axis direction) of the slots S12 and S14 were respectively made to be orthogonal to the extending directions (the Y-axis direction) of the long side 16A of the fourth conductor layer 161 and the long side 16B of the fourth conductor layer 162. Further, as holes which penetrate only the second conductor layer 12, slots S11 and S 13 were formed. The slots S11 and S 13 were formed at positions facing the slots S12 and S14 with the second dielectric layer 23 interposed therebetween. Here, the slots S11 to S 14 were formed to penetrate only the conductor layers and not penetrate the second dielectric layer 23. Further, a plurality of via holes 41 was provided at regular intervals around each of the slots S11 and S12. Similarly, a plurality of via holes 41 was provided at regular intervals around each of the slots S 13 and S 14. Each via hole 41 was penetrated from the third conductor layer 15 via the second dielectric layer 23 to the second conductor layer 12. Non-electrolytic plating 41a was provided on an inner wall of the via hole 41, so that the second conductor layer 12 and the third conductor layer 15 were electrically connected via the inner wall of the via hole 41. At this time, the surfaces of the second conductor layer 12 and the third conductor layer 15 were also subjected to non-electrolytic plating. However, in Fig. 13(b), the illustration of plated films of the surfaces of the second conductor layer 12 and the third conductor layer 15 is omitted for convenience.

The first conductor layer 110 that is a transmission line was further provided below the second conductor layer 12 with the first dielectric layer 21 interposed therebetween. The first conductor layer 110 was formed in a U-shape, as shown in Figs. 12 and 13(a). The extending direction of one end 11A of the first conductor layer 110 was set to be parallel to the extending direction (the Y-axis direction shown in Fig. 13(a)) of the long side 16A of the fourth conductor layer 161. Further, the extending direction of the other end 11B of the first conductor layer 110 was set to be parallel to the extending direction (the Y-axis direction shown in Fig. 13(a)) of the long side 16B of the fourth conductor layer 162. At this time, when viewed from a laminated direction (the Z-axis direction), one end 11A of the first conductor layer 110 was disposed so as to overlap the hole S on one side and the long side 16A of the fourth conductor layer 161 on one side, and the other end 11B of the first conductor layer 110 was also disposed so as to overlap the hole S on the other side and the long side 16B of the fourth conductor layer 162 on the other side.

A specific manufacturing method of the multi-layer transmission-line plate 20A will be described below. First, the plurality of via holes 41 (hole diameter: 0.15 mmϕ, distance between walls of adjacent holes: 0.4 mm, distance between the wall of hole and slot: 0.1 mm) was perforated around each slot which will be formed later by etching in a copper-clad laminated plate (trade name: MCL-E-679 manufactured by Hitachi Chemical Co., Ltd.) having a plate thickness of 0.5 mm and a copper foil thickness of 12 µm, and non-electrolytic plating 41 a was carried out on the inner walls of the via holes. Then, the slots S11 to S 14 each having a size of 0.4 mm×1.9 mm were formed in areas surrounded by the via holes 41 of the copper-clad laminated plate described above. At this time, an inner layer circuit board was fabricated by performing patterning by etching such that the slot S11 and the slot S12 are disposed to face each other and the slot S 13 and the slot S 14 are also disposed to face each other (Step S1). In addition, the extending directions of the slots S11 and S12 and the extending directions of the slots S 13 and S 14 were set to be on the same straight line.

Next, a multi-layer plate was fabricated in which copper foil (trade name: 3EC-VLP-12 manufactured by Mitsui Mining & Smelting Co., Ltd., surface roughness Rz on the dielectric layer side: 3.0 µm) having a thickness of 12 µm, a prepreg (trade name: GFA-2 manufactured by Hitachi Chemical Co., Ltd., thickness: 100 µm), the inner layer circuit board obtained in Step S1, a prepreg (trade name: GFA-2 manufactured by Hitachi Chemical Co., Ltd., thickness: 100 µm), and copper foil (trade name: 3EC-VLP-12 manufactured by Mitsui Mining & Smelting Co., Ltd., surface roughness Rz on the dielectric layer side: 3.0 µm) having a thickness of 12 µm were piled up in this order and laminated and integrated in the conditions of temperature 180°C, pressure 3 MPa, and time 60 minutes (Step S2).

Finally, in the multi-layer plate obtained in Step S2, the upper and lower copper foils were patterned by etching. That is, by patterning the upper copper foil, two L-shaped fourth conductor layers 161 and 162 were obtained. Further, by patterning the lower copper foil, a U-shaped first conductor layer 110 was obtained. At this time, at positions corresponding to the slots S11 and S12 formed in the inner layer circuit board, the long side 16A of the fourth conductor layer 161 that becomes a transmission line having a width of 0.22 mm was made to extend in a direction orthogonal to the long axis directions (the X-axis direction) of the slots S11 and S12. Similarly, at positions corresponding to the slots S 13 and S 14 formed in the inner layer circuit board, the long side 16B of the fourth conductor layer 162 that becomes a transmission line having a width of 0.22 mm was made to extend in a direction orthogonal to the long axis directions (the X-axis direction) of the slots S 13 and S 14. In the way as described above, a slot coupling type interlayer connection structure 1001 was fabricated. Here, a shortest distance L3 from the inside of the long side 16A of the fourth conductor layer 161 on one side which is a transmission line to the inside of the long side 16B of the fourth conductor layer 162 on the other side was 2.58 mm.

### (Measurement Results)

With respect to the electromagnetic field coupling structure 100, the electromagnetic field coupling structure 101, the electromagnetic field coupling structure 102, the electromagnetic field coupling structure 103, the electromagnetic field coupling structure 1000, and the electromagnetic field coupling structure 1001 fabricated in Example 1, Example 2, Example 3, Example 4, Comparative Example 1, and Comparative Example 2, as described above, a high-frequency probe (trade name: ACP-L-GSG150 manufactured by Cascade Microtech, Inc.) was brought into contact with a terminal section (that is, 16C or 16D) for high-frequency measurement, electric power was supplied thereto from a network analyzer (trade name: HP8510C manufactured by Agilent Technologies) connected thereto via a coaxial cable (trade name: E7342 manufactured by Agilent Technologies), and also transmission loss was measured when the electric power passes to an end face of the terminal section for high-frequency measurement.

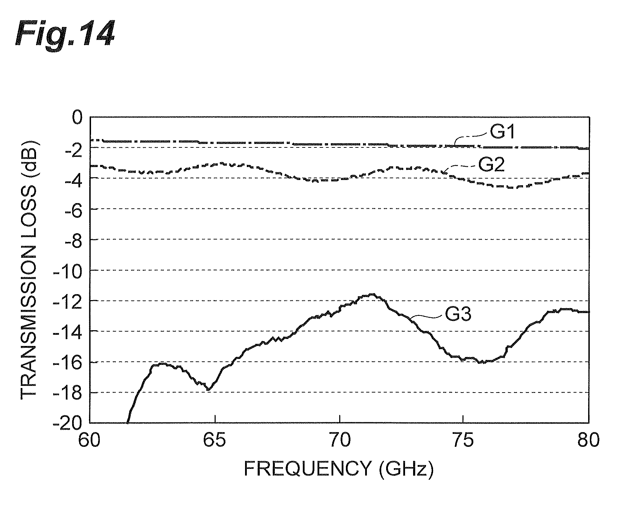

The measured results of transmission loss are shown in Figs. 14 to 17. All the characteristics shown in these graphs are characteristics for two pieces of electromagnetic field coupling via the holes or the slots. Therefore, transmission loss for one piece of electromagnetic field coupling via the hole or the slot becomes a characteristic in which it is approximately a half of transmission loss in these graphs. In addition, in the graph of the measurement result, the transmission loss of a measured microstrip line was also shown together. In this way, the transmission loss of an electromagnetic field coupling section via the hole or the slot was made to be capable of being calculated. Hereinafter, specific description will be given along with the calculation method.

Fig. 14 is a graph showing the measurement results of high frequency characteristics of Example 1 and Comparative Example 1. In Fig. 14, G1 represents the transmission loss of a microstrip line. G2 represents the transmission loss of the electromagnetic field coupling structure 100 for two pieces of electromagnetic field coupling via two holes S of microstrip lines in Example 1. G3 represents the transmission loss of the electromagnetic field coupling structure 1000 for two pieces of electromagnetic field coupling via four slots S 1, S2, S3, and S4 of microstrip lines in Comparative Example 1.

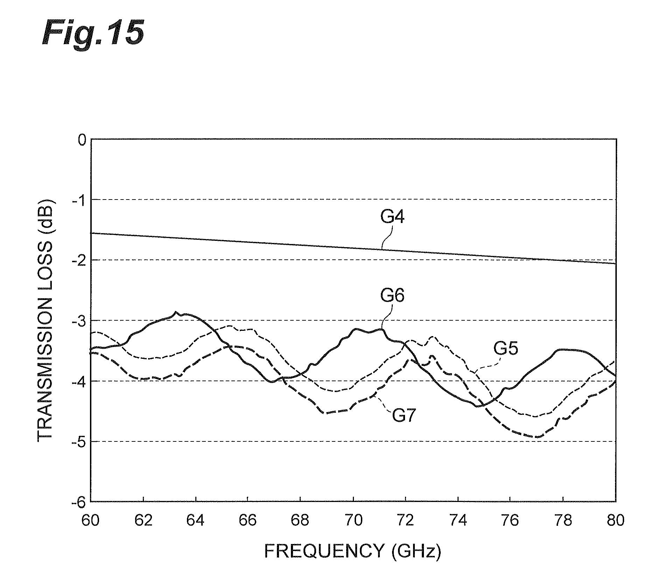

Fig. 15 is a graph showing the measurement results of high frequency characteristics of Examples 1 to 3. In Fig. 15, in G4, the transmission loss of a microstrip line is shown. In G5, the transmission loss of the electromagnetic field coupling structure 100 for two pieces of electromagnetic field coupling via two holes S of microstrip lines in Example 1 is shown. The G5 is the same as G2. In G6, the transmission loss of the electromagnetic field coupling structure 101 for two pieces of electromagnetic field coupling via two holes S of microstrip lines in Example 2 is shown. In G7, the transmission loss of the electromagnetic field coupling structure 102 for two pieces of electromagnetic field coupling via two holes S of microstrip lines in Example 3 is shown.

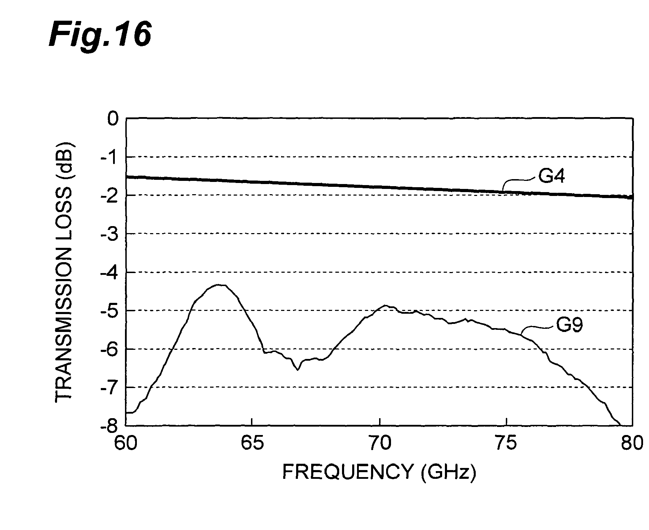

Fig. 16 is a graph showing the measurement results of a high frequency characteristic of Comparative Example 2. In Fig. 16, G4 represents the transmission loss of a microstrip line. G9 represents the transmission loss of the electromagnetic field coupling structure 1001 for two pieces of electromagnetic field coupling via the slots S11 to S 14 surrounded by a plurality of via holes 41 of microstrip lines in Comparative Example 2.

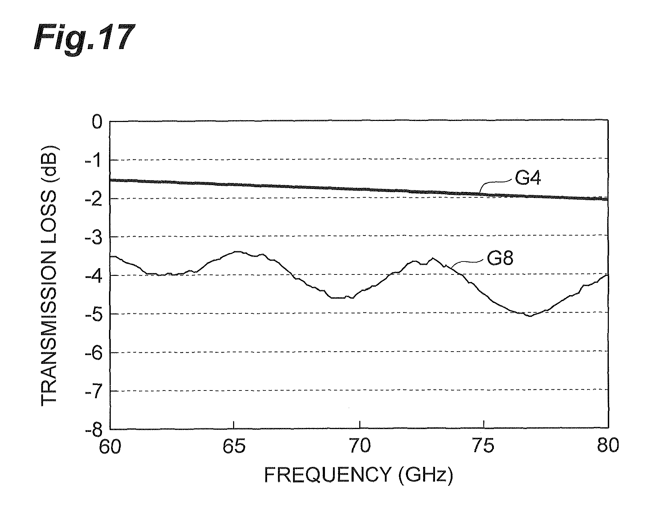

Fig. 17 is a graph showing the measurement results of a high frequency characteristic of Example 4. In Fig. 17, G4 represents the transmission loss of a microstrip line. G8 represents the transmission loss of the electromagnetic field coupling structure 103 for two pieces of electromagnetic field coupling via two holes S of microstrip lines in Example 4.

Further, the characteristics at the time of 71 GHz of the electromagnetic field coupling structure 100, the electromagnetic field coupling structure 101, the electromagnetic field coupling structure 102, the electromagnetic field coupling structure 103, the electromagnetic field coupling structure 1000, and the electromagnetic field coupling structure 1001 1 are shown together in the following Table 1.

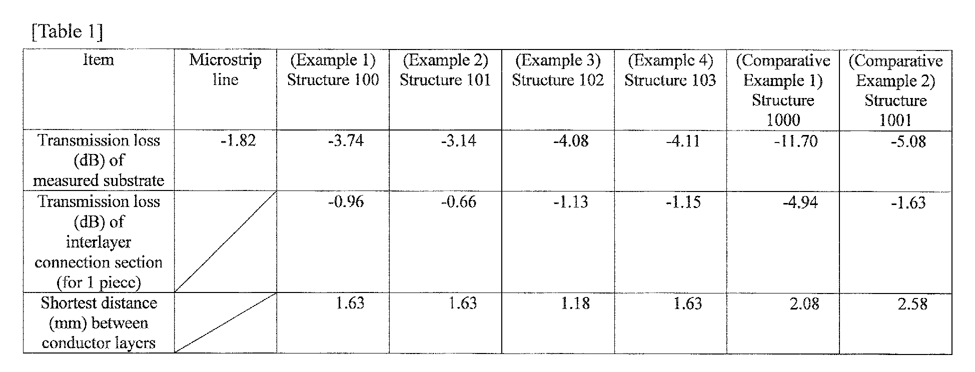

As shown in G2 of Fig. 14, G5 of Fig. 15, or Table 1, at the time of 71 GHz, the transmission loss of a measured substrate in the electromagnetic field coupling structure 100 of Example 1 is -3.74 dB, and if the transmission loss, -1.82 dB, of the microstrip line shown in G1 of Fig. 14, G4 of Fig. 15, or Table 1 is subtracted from the above value, -1.92 dB is obtained. Since the value of -1.92 dB is the transmission loss of the electromagnetic field coupling structure 100 for two pieces of electromagnetic field coupling via the holes of microstrip lines, -0.96 dB that is half the value becomes transmission loss for one piece of electromagnetic field coupling via the hole.

Further, as shown in G6 of Fig. 15 or Table 1, at the time of 71 GHz, the transmission loss of a measured substrate in the electromagnetic field coupling structure 101 of Example 2 is -3.14 dB, and if the transmission loss, -1.82 dB, of the microstrip line shown in G4 of Fig. 15 or Table 1 is subtracted from the above value, -1.32 dB is obtained. Since the value of-1.32 dB is the transmission loss of the electromagnetic field coupling structure 101 for two pieces of electromagnetic field coupling via the holes of microstrip lines, -0.66 dB that is half the value becomes transmission loss for one piece of electromagnetic field coupling via the hole.

As shown in G7 of Fig. 15 or Table 1, at the time of 71 GHz, the transmission loss of a measured substrate in the electromagnetic field coupling structure 102 of Example 3 is -4.08 dB, and if the transmission loss, -1.82 dB, of the microstrip line shown in G1 in Fig. 9 or Table 1 is subtracted from the above value, -2.26 dB is obtained. Since the value of -2.26 dB is the transmission loss of the electromagnetic field coupling structure 102 for two pieces of electromagnetic field coupling via the holes of microstrip lines, -1.13 dB that is half the value becomes transmission loss for one piece of electromagnetic field coupling via the hole.

Further, as shown in G8 of Fig. 17 or Table 1, at the time of 71 GHz, the transmission loss of a measured substrate in the electromagnetic field coupling structure 103 of Example 4 is -4.11 dB, and if the transmission loss, -1.82 dB, of the microstrip line shown in G4 of Fig. 17 or Table 1 is subtracted from the above value, -2.29 dB is obtained. Since the value of -2.29 dB is the transmission loss of the electromagnetic field coupling structure 103 for two pieces of electromagnetic field coupling via the slots of microstrip lines, -1.15 dB that is half the value becomes transmission loss for one piece of electromagnetic field coupling via the slot.

Further, as shown in G3 of Fig. 14 or Table 1, at the time of 71 GHz, the transmission loss of a measured substrate in the electromagnetic field coupling structure 1000 of Comparative Example 1 is -11.70 dB, and if the transmission loss, -1.82 dB, of the microstrip line shown in G1 of Fig. 14 or Table 1 is subtracted from the above value, -9.88 dB is obtained. Since the value of -9.88 dB is the transmission loss of the electromagnetic field coupling structure 101 for two pieces of electromagnetic field coupling via the slots of microstrip lines, -4.94 dB that is half the value becomes transmission loss for one piece of electromagnetic field coupling via the slot.

Further, as shown in G9 of Fig. 16 or Table 1, at the time of 71 GHz, the transmission loss of a measured substrate in the electromagnetic field coupling structure 1001 of Comparative Example 2 is -5.08 dB, and if the transmission loss, -1.82 dB, of the microstrip line shown in G4 of Fig. 16 or Table 1 is subtracted from the above value, -3.26 dB is obtained. Since the value of -3.26 dB is the transmission loss of the electromagnetic field coupling structure 1001 for two pieces of electromagnetic field coupling via the slots of microstrip lines, -1.63 dB that is half the value becomes transmission loss for one piece of electromagnetic field coupling via the slot.

Therefore, transmission loss at a 71 GHz band is considerably smaller in the electromagnetic field coupling structure 100 of Example 1 than the electromagnetic field coupling structure 1000 of Comparative Example 1. Further, as shown in Fig. 14, over a frequency band in a range of 60 GHz to 80 GHz, transmission loss is considerably smaller in the electromagnetic field coupling structure 100 of Example 1 than the electromagnetic field coupling structure 1000 of Comparative Example 1. Further, transmission loss at a 71 GHz band is smaller in the electromagnetic field coupling structure 101 of Example 2 than the electromagnetic field coupling structure 100 of Example 1.

In this manner, compared to the multi-layer transmission-line plate 10A of the related art as in Comparative Example 1 shown in Fig. 11, in the multi-layer transmission-line plate 1A as in Example 1 or Example 2 shown in Fig. 7, transmission loss becomes small. This is due to the fact that in the multi-layer transmission-line plate of the comparative example, electromagnetic field coupling between transmission lines is weak. The reasons that electromagnetic field coupling becomes weak are two. First, it is because the distance between transmission lines becomes distant in proportion to the thickness of a multi-layer structure which is present between the transmission lines. Second, it is because in the multi-layer transmission-line plate of the comparative example, a design method to enhance electromagnetic field coupling by using a "mirror image" relationship is not taken.

In the multi-layer transmission-line plate 1A as in Example 1 or Example 2 shown in Fig. 7(b), electromagnetic field modes over the first conductor layer 110 and the fourth conductor layers 161 and 162 which form transmission lines are in a "mirror image" relationship, with the laminated body of the second conductor layer 12 and the third conductor layer 15 which form ground layers and the tubular metal film 3 which electrically connects the second conductor layer 12 and the third conductor layer 15 interposed therebetween. That is, the laminated body is disposed at the center in the laminated direction of the multi-layer transmission-line plate 1A, which is the center position of the mirror image phenomenon of the transmission line. Since an electromagnetic field is stabilized as a result of this configuration,, so that strong mode coupling can be obtained, transmission loss is suppressed.

In contrast, in the multi-layer transmission-line plate 10A of the related art as in Comparative Example 1 shown in Fig. 11(b), it is possible to make the distance between transmission lines (that is, the distance between the fourth conductor layers 161 and 162 and the first conductor layer 110) small. However, since it is not possible to enhance mode coupling by a mirror image principle, electric power is leaked in the X direction or the Y direction from the second dielectric layer 23 which is present between the slots S1 and S2 or the slots S3 and S4. Further, in the multi-layer transmission-line plate 20A of the related art as in Comparative Example 2 shown in Fig. 12, compared to Comparative Example 1, transmission loss can be kept small. However, compared to Example 1 and Example 2, transmission loss is larger.

Further, in the structure of Comparative Example 2, the shortest distance L3 between the transmission lines is 2.58 mm, whereas in the structures of Examples 1 to 4, the shortest distances L2 between the transmission lines become 1.63 mm in Examples 1, 2, and 4 and 1.18 mm in Example 3, so that the transmission lines can be disposed more closely than in the structure of Comparative Example 2. In Example 3, since the hole is filled with a dielectric having dielectric loss tangent at 10 GHz of 0.0300 and relative permittivity of 15 and as a result, the effective wavelength passing through the inside of the hole becomes short, it is possible to narrow the width of the hole, so that the transmission lines can be disposed in higher density.

Further, in the structure of Example 4, as the entire thickness of the transmission-line plate is slightly thick compared to the case of Example 1, transmission loss becomes slightly large. However, transmission loss is sufficiently small compared to the case of Comparative Example 1. Further, in the structure of Example 4, the shortest distance L2 between the transmission lines is also small, so that the transmission lines can be disposed more closely than in the structure of Comparative Example 2.

That is, if the electromagnetic field coupling structures of Examples 1 to 4 are adopted, there is the advantage that the transmission lines can be disposed more closely than in the structure of the related art as in Comparative Examples 1 and 2 and transmission loss can also be kept low.

In addition, like the first conductor layers 110 shown in Figs. 7(a), 8(a), 11(a), and 13(a), in order to perform transmission loss measurement, for convenience, the transmission line was formed in an L-shape or a U-shape. That is, since the short side 16C of the fourth conductor layer 161, the short side 16D of the fourth conductor layer 162, and the connection portion 11 C of the first conductor layer 110 are merely provided for convenience for probe measurement, the extending directions of these members are not particularly taken into account when examining the extending direction of the hole S or the slot described above.

### Reference Signs List

- 1:: multi-layer transmission-line plate
- 3:: tubular metal film
- 4:: dielectric
- 11:: first conductor layer
- 12:: second conductor layer
- 15:: third conductor layer
- 16:: fourth conductor layer
- 21:: first dielectric layer
- 23:: second dielectric layer
- 25:: third dielectric layer
- 30:: laminated body
- S:: hole
- S1 to S4, S11 to S14:: slot

## Claims

1. An electromagnetic field coupling structure used in a microwave band frequency band, comprising:
a laminated body comprising an inner dielectric layer sandwiched and laminated between a plurality of inner conductor layers becoming a plurality of ground layers;
a pair of outer dielectric layers facing each other with the laminated body interposed therebetween; and
a pair of outer conductor layers facing each other with the pair of outer dielectric layers interposed therebetween,
wherein the laminated body is provided with a hole penetrating the inner dielectric layer and the plurality of inner conductor layers becoming the plurality of ground layers, and
the plurality of inner conductor layers becoming the plurality of ground layers are electrically connected via a tubular metal film formed on an inner wall of the hole, to electromagnetically couple the pair of outer conductor layers.

2. An electromagnetic field coupling structure used in a microwave band frequency band, comprising:
a first conductor layer, a first dielectric layer, a second conductor layer, a second dielectric layer, a third conductor layer, a third dielectric layer, and a fourth conductor layer in this order,
wherein a hole penetrating the second conductor layer, the second dielectric layer, and the third conductor layer is provided, and
the second conductor layer and the third conductor layer are electrically connected via a tubular metal film formed on an inner wall of the hole, to electromagnetically couple the first conductor layer to the fourth conductor layer.

3. The electromagnetic field coupling structure according to Claim 1 or 2, wherein the tubular metal film is a plated film.

4. A multi-layer transmission-line plate used in a microwave band frequency band, comprising:
a laminated body comprising an inner dielectric layer sandwiched and laminated between a plurality of inner conductor layers becoming a plurality of ground layers;
a pair of outer dielectric layers facing each other with the laminated body interposed therebetween; and
a pair of outer conductor layers facing each other with the pair of outer dielectric layers interposed therebetween and forming the transmission lines,
wherein the laminated body is provided with a hole penetrating the inner dielectric layer and the plurality of inner conductor layers becoming the plurality of ground layers, and
the plurality of inner conductor layers becoming the plurality of ground layers are electrically connected via a tubular metal film formed on an inner wall of the hole, to electromagnetically couple the pair of outer conductor layers.

5. A multi-layer transmission-line plate used in a microwave band frequency band, comprising:
a first conductor layer forming a first transmission line, a first dielectric layer, a second conductor layer, a second dielectric layer, a third conductor layer, and a third dielectric layer, and a fourth conductor layer forming a second transmission line, in this order,
wherein a hole penetrating the second conductor layer, the second dielectric layer, and the third conductor layer is provided, and
the second conductor layer and the third conductor layer are electrically connected via a tubular metal film formed on an inner wall of the hole, to electromagnetically couple the first conductor layer to the fourth conductor layer.

6. The multi-layer transmission-line plate according to Claim 4 or 5, wherein the tubular metal film is a plated film.

7. The electromagnetic field coupling structure according to Claim 1, wherein the outer conductor layers extend in in-plane directions of the pair of outer dielectric layers, and
the width of the hole in a direction orthogonal to extending directions of the outer conductor layers is set to be equal to or less than an effective wavelength corresponding to a frequency used in the frequency band.

8. The electromagnetic field coupling structure according to Claim 2, wherein the first conductor layer extends in an in-plane direction of the first dielectric layer,
the fourth conductor layer extends in an in-plane direction of the third dielectric layer, and
the width of the hole in a direction orthogonal to an extending direction of the fourth conductor layer is set to be equal to or less than an effective wavelength corresponding to a frequency used in the frequency band.

9. The multi-layer transmission-line plate according to Claim 4, wherein the pair of outer conductor layers forming the transmission lines extends in in-plane directions of the pair of outer dielectric layers, and
the width of the hole in a direction orthogonal to extending directions of the pair of outer conductor layers forming the transmission lines is set to be equal to or less than an effective wavelength corresponding to a frequency used in the frequency band.

10. The multi-layer transmission-line plate according to Claim 5, wherein the first conductor layer forming the first transmission line extends in an in-plane direction of the first dielectric layer,
the fourth conductor layer forming the second transmission line extends in an in-plane direction of the third dielectric layer, and
the width of the hole in a direction orthogonal to an extending direction of the fourth conductor layer is set to be equal to or less than an effective wavelength corresponding to a frequency used in the frequency band.

11. The electromagnetic field coupling structure according to any one of Claims 1, 2, 3, 7, and 8, wherein the hole with the tubular metal film formed therein is filled with a dielectric that satisfies at least one of a dielectric loss tangent at 10 GHz in a range of 0 to 0.0300 and a relative permittivity at 10 GHz in a range of 2 to 30.

12. The electromagnetic field coupling structure according to any one of Claims 1, 2, 3, 7, and 8, wherein the hole with the tubular metal film formed therein is filled with air.

13. The multi-layer transmission-line plate according to any one of Claims 4, 5, 6, 9, and 10, wherein the hole with the tubular metal film formed therein is filled with a dielectric that satisfies at least one of a dielectric loss tangent at 10 GHz in a range of 0 to 0.0300 and a relative permittivity at 10 GHz in a range of 2 to 30.

14. The multi-layer transmission-line plate according to any one of Claims 4, 5, 6, 9, and 10, wherein the hole with the tubular metal film formed therein is filled with air.

15. A method of manufacturing an electromagnetic field coupling structure used in a microwave band frequency band, the method comprising:
a step of forming a laminated body comprising an inner dielectric layer disposed between a plurality of inner conductor layers becoming a plurality of ground layers;
a step of providing a hole penetrating the inner dielectric layer and the plurality of inner conductor layers becoming the plurality of ground layers in the laminated body;
a step of providing a tubular metal film on an inner wall of the hole;
a step of forming a pair of outer dielectric layers facing each other with the laminated body interposed therebetween; and
a step of forming a pair of outer conductor layers facing each other with the pair of outer dielectric layers interposed therebetween.

16. The method of manufacturing an electromagnetic field coupling structure according to Claim 15, wherein the tubular metal film is formed by plating.

17. The method of manufacturing an electromagnetic field coupling structure according to Claim 15 or 16, further comprising: a step of filling the hole with the tubular metal film formed therein, with a dielectric that satisfies at least one of a dielectric loss tangent at 10 GHz in a range of 0 to 0.0300 and a relative permittivity at 10 GHz in a range of 2 to 30.

18. The method of manufacturing an electromagnetic field coupling structure according to Claim 15 or 16, further comprising: a step of filling the hole with the tubular metal film formed therein, with air.

19. A method of manufacturing a multi-layer transmission-line plate used in a microwave band frequency band, the method comprising:
a step of forming a laminated body comprising an inner dielectric layer disposed between a plurality of inner conductor layers becoming a plurality of ground layers;
a step of providing a hole penetrating the inner dielectric layer and the plurality of inner conductor layers becoming a plurality of ground layers in the laminated body;
a step of providing a tubular metal film on an inner wall of the hole;
a step of forming a pair of outer dielectric layers facing each other with the laminated body interposed therebetween; and
a step of forming a pair of outer conductor layers facing each other with the pair of outer dielectric layers interposed therebetween.

20. The method of manufacturing a multi-layer transmission-line plate according to Claim 19, wherein the tubular metal film is formed by plating.

21. The method of manufacturing a multi-layer transmission-line plate according to Claim 19 or 20, further comprising: a step of filling the hole with the tubular metal film formed therein, with a dielectric that satisfies at least one of a dielectric loss tangent at 10 GHz in a range of 0 to 0.0300 and a relative permittivity at 10 GHz in a range of 2 to 30.

22. The method of manufacturing a multi-layer transmission-line plate according to Claim 19 or 20, further comprising: a step of filling the hole with the tubular metal film formed therein, with air.
